# EUROPEAN PATENT APPLICATION

(11) **EP 4 671 934 A1**
(43) Date of publication of application: **31.12.2025**
(21) Application number: 25183990.8
(22) Date of filing: 19.06.2025
(51) Int. Cl.: G06F 3/041, G06F 3/044, H10K 59/40, H10K 59/38, H10K 59/80

(54) **DISPLAY DEVICE AND ELECTRONIC DEVICE INCLUDING THE SAME**

(30) Priority: 28.06.2024 KR 20240085545
(71) Applicant: Samsung Display Co., Ltd., Yongin-si, Gyeonggi-do 17113 (KR)
(72) Inventor: YOO, Gi Na, 17113 Yongin-si (KR)
(74) Representative: Walaski, Jan Filip

(57) **Abstract**

A display device includes pixels including light emitting elements disposed in respective emission areas, conductive patterns disposed in a touch sensing layer on the light emitting elements and including a touch electrode, a first light blocking layer disposed on the touch sensing layer and disposed in a non-emission area around the emission areas to surround the emission areas, and a second light blocking layer disposed on the first light blocking layer and surrounding the emission areas of some of the pixels, and the display device further includes a light blocking pattern disposed in the same layer as at least one of the conductive patterns of the touch sensing layer and surrounding the emission areas of the some pixels.

## Description

### CROSS-REFERENCE TO RELATED APPLICATION

This application claims priority from Korean Patent Application No. 10-2024-0085545 filed on 28 June 2024 in the Korean Intellectual Property Office.

### BACKGROUND

### TECHNICAL FIELD

The present disclosure relates to a display device and an electronic device including the same.

### DESCRIPTION OF THE RELATED ART

The advance of our information-oriented society has placed increasing demands on display devices. In accordance with this trend, various types of display devices including light emitting display devices are being developed.

### SUMMARY

In accordance with an aspect of the present disclosure, a display device may be capable of varying a side viewing angle of an image displayed in a display area and preventing leakage of side light from at least some pixels, and an electronic device include the same.

According to an aspect of the present disclosure, a display device may include first and second pixels including light emitting elements disposed in respective emission areas, conductive patterns disposed in a touch sensing layer on the light emitting elements and including a touch electrode, a first light blocking layer disposed on the touch sensing layer and disposed in a non-emission area around the emission areas to surround the emission areas, and a second light blocking layer disposed on the first light blocking layer and surrounding the emission areas of the second pixels. The display device may further include a light blocking pattern disposed in the same layer as at least one of the conductive patterns of the touch sensing layer and surrounding the emission areas of the second pixels.

In an embodiment, the conductive patterns may further include a bridge pattern electrically connected to the touch electrode, and one of the touch electrode and the bridge pattern may be disposed in the same layer as the light blocking pattern and may contain the same material as the light blocking pattern.

In an embodiment, the touch sensing layer may include a first conductive layer including the bridge pattern, a second conductive layer including the touch electrode, and an insulating layer disposed between the first conductive layer and the second conductive layer.

In an embodiment, the first conductive layer may further include the light blocking pattern, and the bridge pattern and the light blocking pattern may be spaced apart from each other.

In an embodiment, the first conductive layer may further include the light blocking pattern, and the bridge pattern and the light blocking pattern may be integral with each other.

In an embodiment, the insulating layer may be disposed on the first conductive layer, and the second conductive layer may be disposed on the insulating layer.

In an embodiment, the first conductive layer may further include the light blocking pattern, and the light blocking pattern may be disposed closer to the light emitting elements of the second pixels than are the touch electrode and the first light blocking layer.

In an embodiment, the second conductive layer may further include the light blocking pattern.

In an embodiment, the insulating layer may include a dummy hole overlapping the light blocking pattern under the light blocking pattern, and a part of the light blocking pattern may be in or fill the dummy hole.

In an embodiment, the light blocking pattern may be disposed closer to the emission areas of the second pixels than is the touch electrode.

In an embodiment, each of the pixels may include a plurality of emission areas including a first emission area emitting light of a first color, a second emission area emitting light of a second color, and a third emission area emitting light of a third color.

In an embodiment, the light blocking pattern may individually surround the plurality of emission areas disposed in each of the second pixels.

In an embodiment, the light blocking pattern may collectively surround the plurality of emission areas disposed in each of the second pixels.

In an embodiment, the touch electrode and the light blocking pattern may be disposed in different conductive layers included in the touch sensing layer and may not overlap each other.

In an embodiment, the touch electrode and the light blocking pattern may be disposed in different conductive layers included in the touch sensing layer and may partially overlap each other.

In an embodiment, the first light blocking layer may cover the touch electrode and the light blocking pattern.

In an embodiment, the second light blocking layer may overlap a part of the first light blocking layer.

In an embodiment, the pixels may include first pixels around which the second light blocking layer is not disposed, and second pixels around which the second light blocking layer is disposed.

In an embodiment, the first light blocking layer may include openings exposing the emission areas of the first pixels and openings exposing the emission areas of the second pixels, and a first size of the openings of the first light blocking layer exposing the emission areas of the first pixels and a second size of the openings of the first light blocking layer exposing the emission areas of the second pixels may be different.

In an embodiment, the first size may be greater than the second size.

According to an aspect of the present disclosure, an electronic device may include a display device, the display device including first and second pixels including light emitting elements disposed in respective emission areas, conductive patterns disposed in a touch sensing layer on the light emitting elements and including a touch electrode, a first light blocking layer disposed on the touch sensing layer and disposed in a non-emission area around the emission areas to surround the emission areas, a second light blocking layer disposed on the first light blocking layer and surrounding the emission areas of the second pixels, and a light blocking pattern disposed in the same layer as at least one of the conductive patterns of the touch sensing layer and surrounding the emission areas of the second pixels.

In accordance with an embodiment, the light exit angle or side viewing angle of first pixels and second pixels disposed in the display area of the display device may be differentiated or optimized using a first light blocking layer and a second light blocking layer. Accordingly, the side viewing angle of the image displayed in the display area may be appropriately varied in response to each emission mode selected by a user.

Further, in accordance with an embodiment, a light blocking pattern in a touch sensing layer in a non-emission area of the second pixels may help prevent leakage of side light from the second pixels.

Aspects of the present disclosure are not restricted to the ones set forth above. Other aspects of the present disclosure will become more apparent to one of ordinary skill in the art to which the present disclosure pertains by referencing the detailed description given below. Additionally, effects according to the embodiments of the present disclosure are not limited to those exemplified above and various other effects are incorporated herein.

### BRIEF DESCRIPTION OF THE DRAWINGS

The above and other aspects and features of the present disclosure will become more apparent by describing in detail embodiments thereof with reference to the attached drawings.
FIG. 1 is a perspective view of an electronic device.
FIG. 2 is a perspective view of a display device for an electronic device.
FIG. 3 is a cross-sectional view of the display device of FIG. 2 viewed from the side.
FIG. 4 is a plan view of a display area of a display device.
FIG. 5 is a plan view illustrating an arrangement of pixel electrodes.
FIG. 6 is a plan view illustrating an arrangement of pixel electrodes, a first light blocking layer, and color filters.
FIG. 7 is a plan view illustrating an arrangement of pixel electrodes and a second light blocking layer.
FIG. 8 is a plan view of a display area of a display device.
FIG. 9 is a cross-sectional view of a display device.
FIG. 10 is a cross-sectional view of a display device.
FIG. 11 is a cross-sectional view of a display device;
FIG. 12 is a cross-sectional view of a display device.
FIG. 13 is a cross-sectional view of a display device.
FIG. 14 is a cross-sectional view of a display device.
FIG. 15 is a cross-sectional view of a display device.
FIG. 16 is a cross-sectional view of a display device.
FIG. 17 is a cross-sectional view of a display device.
FIG. 18 is a cross-sectional view of a display device.
FIG. 19 is a cross-sectional view of a display device.
FIG. 20 is a cross-sectional view of a display device.;
FIG. 21 is a cross-sectional view of a display device.
FIGS. 22 to 26 are plan views of display areas of display devices.

### DETAILED DESCRIPTION OF THE EMBODIMENTS

Example embodiments in accordance with the present disclosure are described more fully below with reference to the accompanying drawings, in which the same reference numbers in different figures identify the same or similar components. Other embodiments may take different forms, and this disclosure should not be construed as being limited to the example embodiments. Rather, the example embodiments are illustrated and described so that this disclosure will be thorough and complete and understood by those skilled in the art.

An element or a layer referred to herein as being "on" another element or layer may be directly on the other element or layer or intervening elements or layers may also be present.

Although the terms "first," "second," etc. may be used herein to describe various elements, the elements should not be limited by these terms. These terms are only used to distinguish one element from another element. For instance, a first element discussed below could be termed a second element without departing from the teachings of the present disclosure. Similarly, the second element could also be termed the first element.

Features of each of various embodiments of the present disclosure may be partially or entirely combined with each other and may variously interwork with each other, and respective embodiments may be implemented independently of each other or may be implemented together in association with each other.

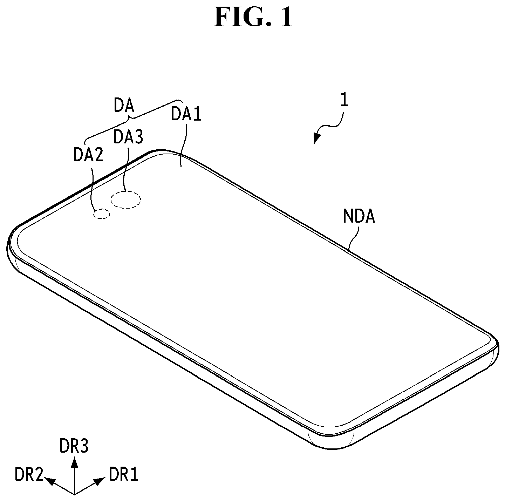

FIG. 1 is a perspective view of an electronic device.

Referring to FIG. 1, an electronic device 1 may display a moving image or a still image. The electronic device 1 may be any electronic device having a display screen. Examples of the electronic device 1 may include a television, a laptop computer, a monitor, a billboard, an Internet-of-Things device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder and the like, which provide or include a display screen.

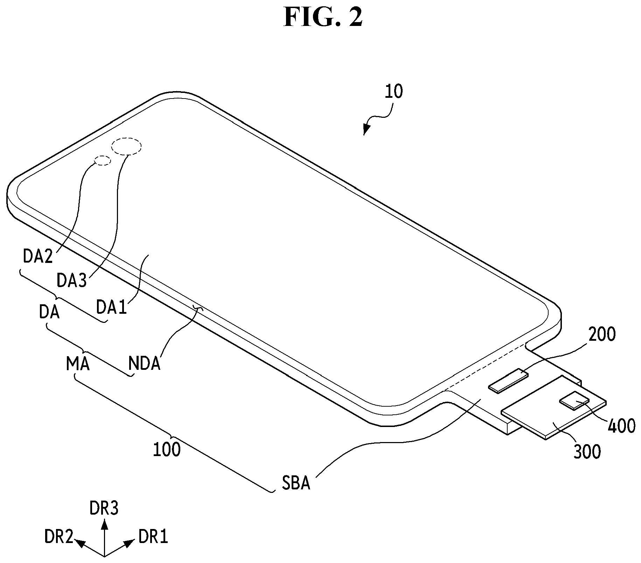

The electronic device 1 may include a display device (e.g., a display device 10 of FIG. 2) that provides the display screen. The display device may be a light emitting display device including light emitting elements such as inorganic light emitting diodes or organic light emitting diodes, but the electronic device 1 is not limited thereto. For example, although a light emitting display device including an organic light emitting diode may be described as an example of a display device, devices or fields are not limited thereto. For example, embodiments may also be applied to other types of display devices.

The electronic device 1 may have various shapes. For example, the electronic device 1 may have a shape such as a rectangular shape elongated in a horizontal direction, a rectangular shape elongated in a vertical direction, a square shape, a substantially quadrilateral shape with rounded corners, other polygonal shapes and a circular shape. The electronic device 1 may have a display area DA having a shape similar to the overall shape of the electronic device 1, but the display area DA is not limited thereto. FIG. 1 shows an example in which the electronic device 1 has a generally rectangular shape that is longer in a second direction DR2 than in a first direction DR1.

The electronic device 1 may include the display area DA and a non-display area NDA. The display area DA is an area where an image can be displayed, and the non-display area NDA is an area where an image is not displayed. The display area DA may also be referred to as an active region, and the non-display area NDA may also be referred to as a non-active region. The display area DA may substantially occupy the center of the electronic device 1.

The display area DA may include a first display area DA1, a second display area DA2, and a third display area DA3. The second display area DA2 and the third display area DA3 may be areas in which components for adding various functions to the electronic device 1 are disposed, and the second display area DA2 and the third display area DA3 may correspond to a component area. Although FIG. 1 shows an example in which the electronic device 1 includes two component areas, the number or location of the component areas is not limited to that illustrated.

FIG. 2 is a perspective view of a display device for an electronic device.

Referring to FIGS. 1 and 2, the electronic device 1 may include the display device 10. The display device 10 may provide a screen of the electronic device 1. The display device 10 may have a planar shape similar to the shape of the electronic device 1. For example, the display device 10 may have a shape similar to a rectangular shape having short sides extending in the first direction DR1 and long sides extending in the second direction DR2. Corners where the short sides and the long side meet may be rounded, but the corners are not limited thereto and may form a sharp or right angle. The planar shape of the display device 10 is not limited to a quadrilateral shape, and may have another polygonal shape, a circular shape, an elliptical shape, or another shape.

The display device 10 may include a display panel 100, a display driver 200, a circuit board 300, and a touch driver 400.

The display panel 100 may include a main region MA and a sub-region SBA.

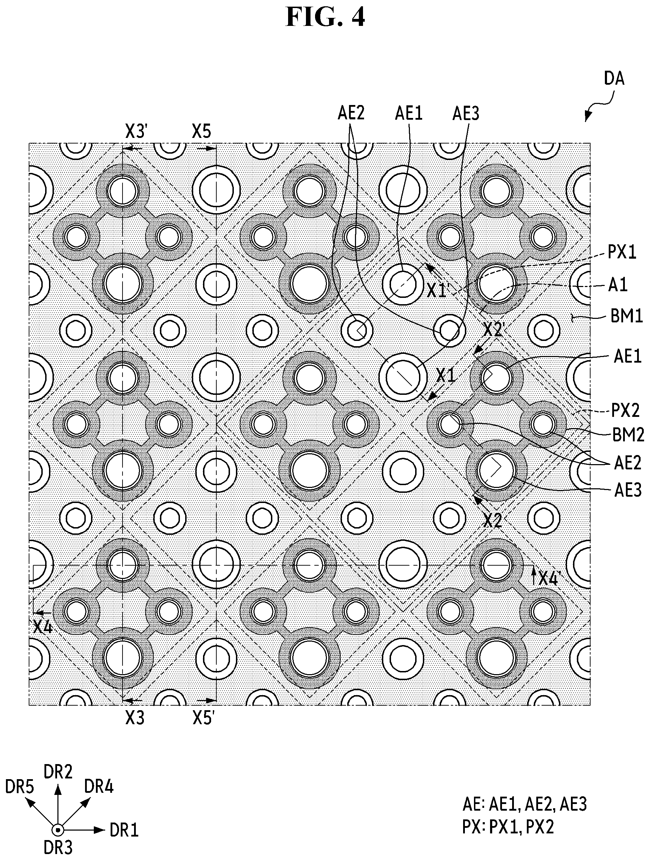

The main region MA may include the display area DA including pixels PX (e.g., pixels PX of FIG. 4) displaying an image and the non-display area NDA disposed around the display area DA. The display area DA may be disposed in the center of the main region MA, and the non-display area NDA may surround the display area DA.

The display area DA may include the first display area DA1, the second display area DA2, and the third display area DA3. The display area DA may include emission areas of the pixels PX, and light may be emitted from the emission areas.

The display panel 100 may include light emitting elements and pixel circuits (e.g., pixel circuits including transistors and capacitors) of the pixels PX, and a pixel defining film surrounding the emission areas of the pixels PX. The light emitting element of each of the pixels PX may be disposed in the emission area of the corresponding pixel PX. Each light emitting element may include one of an organic light emitting diode (LED) including an organic light emitting layer, a quantum dot LED including a quantum dot light emitting layer, an inorganic LED including an inorganic semiconductor, and an ultrasmall light emitting diode such as a micro LED or nano LED, but the light emitting elements are not limited thereto.

The non-display area NDA may be an area outside the display area DA. The non-display area NDA may be defined as an edge area of the main region MA of the display panel 100. The non-display area NDA may include a gate driver (not illustrated) that supplies gate signals to the gate lines, and fan-out lines (not illustrated) that connect the display driver 200 to the display area DA.

The sub-region SBA may be a region extending from one side of the main region MA. The sub-region SBA may include a flexible material that can be bent, folded or rolled. For example, when the sub-region SBA is bent (or folded), the sub-region SBA may overlap the main region MA in a thickness direction (a third direction DR3). For example, when the display device 10 is bent in the sub-region SBA, at least a part of the sub-region SBA including an area where the display driver 200 is disposed and an area where a pad portion connected to the circuit board 300 is disposed may be disposed under the main region MA.

The sub-region SBA may include the display driver 200 and a pad portion connected to the circuit board 300. The sub-region SBA may be omitted, and the display driver 200 and the pad portion may be disposed in the non-display area NDA. The display driver 200 may be disposed on the circuit board 300 connected to the display panel 100 and may be electrically connected to the display panel 100 through the pad portion.

The display driver 200 may output driving signals and driving voltages for driving the display panel 100. For example, the display driver 200 may supply data voltages to data lines, supply driving voltages (e.g., first pixel voltage (or anode voltage) and second pixel voltage (or cathode voltage)) to power lines, and supply gate control signals to the gate driver. The display driver 200 may be an integrated circuit (IC) mounted on the display panel 100 by a chip on glass (COG) method, a chip on plastic (COP) method, or an ultrasonic bonding method.

The circuit board 300 may be attached to the pad portion of the display panel 100 using an anisotropic conductive film (ACF) or the like. Lead lines of the circuit board 300 may be electrically connected to the pad portion of the display panel 100. The circuit board 300 may be a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply touch drive signals to touch electrodes of the touch sensing unit and may sense changes in capacitances between the touch electrodes. The touch driving signal may be a pulse signal having a predetermined frequency. The touch driver 400 may detect whether or not a touch input has occurred and determine coordinates of the touch input based on the change in capacitance between the touch electrodes. The touch driver 400 may be an integrated circuit (IC).

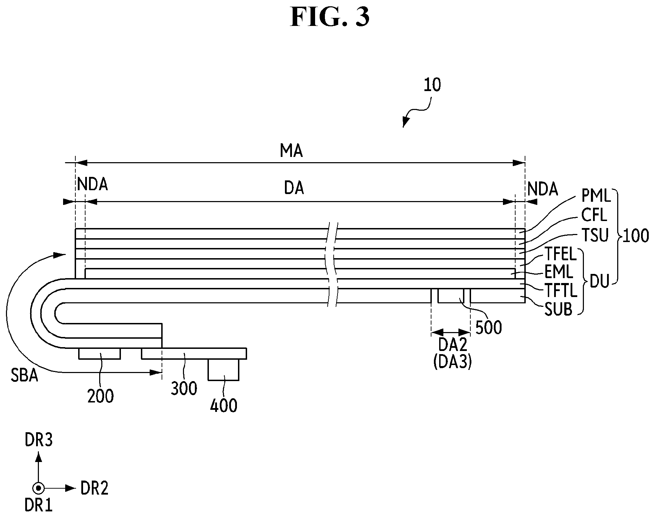

FIG. 3 is a cross-sectional view of the display device 10 when the sub-region SBA of the display panel 100 is in a bent state.

Referring to FIG. 3, the display panel 100 may include a display layer DU, a touch sensing layer TSU, a color filter layer CFL, and a light blocking member layer PML. Although the color filter layer CFL and the light blocking member layer PML are separately illustrated in FIG. 3, the color filter layer CFL and the light blocking member layer PML may be integrated into one light control layer.

The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate that can be bent, folded, or rolled but is not limited thereto. The substrate SUB may include a polymer resin such as polyimide (PI). The substrate SUB may include a glass material or a metal material.

The thin film transistor layer TFTL may be disposed on the substrate SUB. The thin film transistor layer TFTL may include circuit elements, e.g., thin film transistors and capacitors, constituting pixel circuits of pixels. The thin film transistor layer TFTL may further include wires. For example, the thin film transistor layer TFTL may further include gate lines, data lines, power lines, gate control lines, fan-out lines that connect the display driver 200 to the data lines, and lead lines that connect the display driver 200 to the pad portion. Each of the thin film transistors may include a semiconductor region, a source electrode, a drain electrode, and a gate electrode. When the display panel 100 includes the gate driver disposed in the non-display area NDA, the thin film transistor layer TFTL may further include circuit elements constituting the gate driver.

The thin film transistor layer TFTL may be disposed in the display area DA, the non-display area NDA, and the sub-region SBA. The circuit elements constituting the pixel circuits of the pixels, and the gate lines, the data lines, and the power lines that are electrically connected to the pixels may be disposed in the display area DA of the thin film transistor layer TFTL. The gate lines, the data lines, and the power lines may extend to the non-display area NDA of the thin film transistor layer TFTL and may be electrically connected to the gate driver, the display driver 200, or the pad portion. The gate control lines and the fan-out lines may be disposed in the non-display area NDA of the thin film transistor layer TFTL. The lead lines may be disposed in the sub-region SBA of the thin film transistor layer TFTL.

The light emitting element layer EML may be disposed on the thin film transistor layer TFTL. The light emitting element layer EML may include a pixel defining film that defines emission areas of pixels, and light emitting elements disposed in the emission areas. Each emission area may be disposed in a corresponding pixel area of the display area DA. For example, the pixel area where the respective pixels of the display area DA are disposed may include a pixel circuit area where circuit elements constituting the pixel circuit of the corresponding pixel are disposed and an emission area where the light emitting element of the corresponding pixel is disposed. The emission area and the pixel circuit area of each pixel may overlap each other in the third direction DR3.

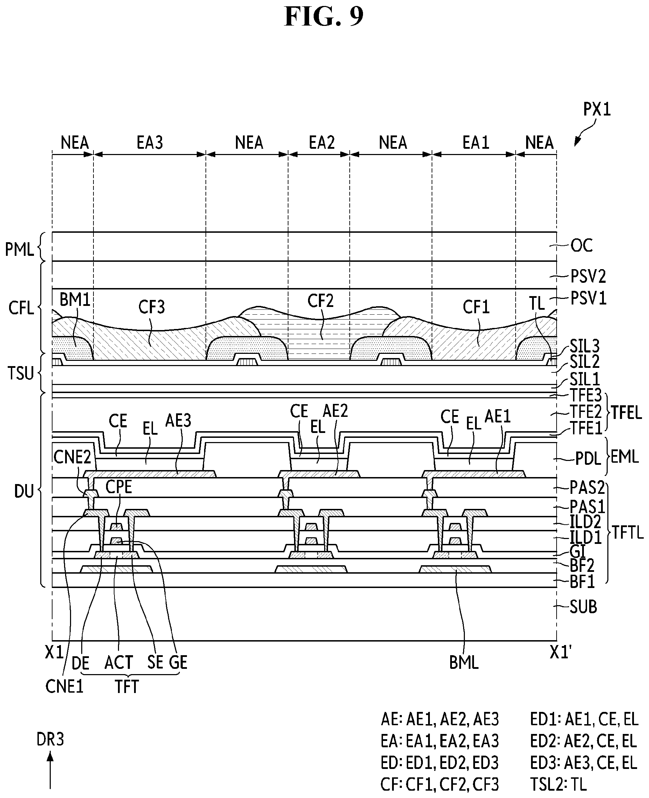

Each light emitting element may include a first electrode and a second electrode facing each other, and a light emitting layer interposed between the first electrode and the second electrode. The first electrode of the light emitting element may correspond to the pixel electrode shown in FIG. 4 and subsequent drawings, and the second electrode of the light emitting element may correspond to the common electrode shown in FIG. 9 and subsequent drawings. The light emitting layer may be an organic light emitting layer including an organic material. The light emitting layer may include a hole transporting layer, an organic light emitting layer, and an electron transporting layer. When a first pixel voltage (e.g., anode voltage) is applied to the first electrode of the light emitting element through at least one of the thin film transistors of each pixel circuit, and a second pixel voltage (e.g., cathode voltage) is applied to the second electrode of the light emitting element through the power line, holes and electrons may recombine in an organic light emitting layer and the light emitting element may emit light. The light emitting element may be another type of light emitting element, such as a quantum dot light emitting diode including a quantum dot light emitting layer, an inorganic light emitting diode including an inorganic semiconductor, a micro light emitting diode, or a nano light emitting diode.

The encapsulation layer TFEL may cover the top surface and the side surface of the light emitting element layer EML and may protect the light emitting element layer EML. The encapsulation layer TFEL may include at least one inorganic film and at least one organic film for encapsulating the light emitting element layer EML. For example, the encapsulation layer TFEL may include a plurality of inorganic encapsulation layers and one or more organic encapsulation layers interposed between the inorganic encapsulation layers.

The touch sensing layer TSU may be disposed on the display layer DU. For example, the touch sensing layer TSU may be disposed or formed on the encapsulation layer TFEL, or the touch sensing layer TSU may be disposed on a separate substrate attached to the display layer DU.

The touch sensing layer TSU may include touch electrodes for sensing the user's touch input, and wires that electrically connect the touch electrodes to the touch driver 400. The touch sensing layer TSU may sense the user's touch in a mutual capacitance manner or a self-capacitance manner, and the touch electrodes may have a shape needed for a mutual capacitance type or self-capacitance type touch sensor. For example, the touch electrodes may include driving electrodes and sensing electrodes extending and/or connected in different directions to constitute a mutual capacitance type touch sensor or may include touch electrodes disposed at points corresponding to respective touch nodes or coordinates to constitute a self-capacitance type touch sensor.

The touch electrodes of the touch sensing layer TSU may be disposed in a touch sensor area overlapping the display area DA. The area in the display area DA where the touch electrodes are disposed may be the touch sensor area. For example, the touch sensor area may be all or a part of the display area DA. Wires electrically connected to the touch electrodes of the touch sensing layer TSU may be disposed in a peripheral area overlapping the non-display area NDA.

The color filter layer CFL may be disposed on the touch sensing layer TSU. The color filter layer CFL may include color filters corresponding to the respective emission areas of the pixels. Each of the color filters may selectively transmit light of a specific wavelength and may block or absorb light of a different wavelength. The color filter layer CFL may further include a first light blocking layer (or first light blocking patterns forming the first light blocking layer) surrounding the emission areas of the pixels. The first light blocking layer may be formed separately from the color filters by using a separate light blocking material or may be formed by overlapping a plurality of color filters that selectively transmit light of different wavelengths.

The color filter layer CFL may absorb some light coming from the outside of the display device 10 and may thereby reduce reflection of external light. The color filter layer CFL may prevent reflection of external light from distorting color in an image.

The color filter layer CFL may be disposed directly on the touch sensing layer TSU. Accordingly, the display device 10 may not include a separate substrate for the color filter layer CFL, which may help reduce the thickness of the display device 10.

The light blocking member layer PML may be disposed on the color filter layer CFL. The light blocking member layer PML may include a second light blocking layer (or second light blocking patterns forming the second light blocking layer) disposed to correspond to some specific pixels of the display layer DU. For example, the light blocking member layer PML may include the second light blocking layer that is directly adjacent to the emission areas of a specific subset of the pixels, and the second light blocking layer may surround the emission areas in a plan view.

The light blocking member layer PML may limit the viewing angle of the image displayed by the specific pixels. For example, the display device 10 includes the light blocking member layer PML and thus may control visibility at a specific viewing angle and provide a side viewing angle blocking mode, such as a privacy protection mode, to a user.

The display device 10 may further include an optical device 500 disposed in a component area (e.g., the second display area DA2 or the third display area DA3 of FIGS. 1 and 2). The optical device 500 may emit or receive light in infrared, ultraviolet, and visible light bands. For example, the optical device 500 may be an optical sensor that detects light incident on the display device 10 and may particularly be a proximity sensor, an illuminance sensor, a camera sensor, or an image sensor.

FIG. 4 is a plan view illustrating a display area of a display device. FIG. 4 particularly shows pixel electrodes AE disposed in the display area DA of the display device 10 and a first light blocking layer BM1 and a second light blocking layer BM2 disposed around the pixel electrodes AE.

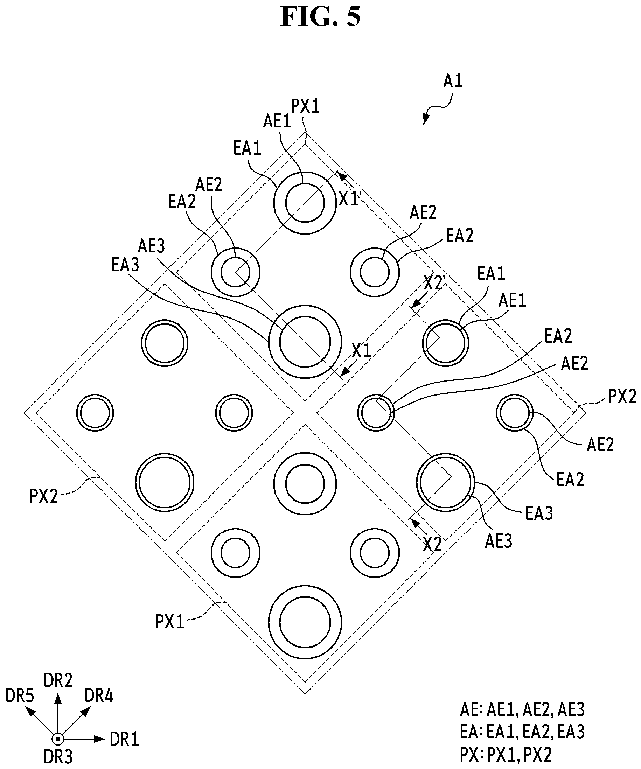

FIG. 5 is a plan view illustrating pixel electrodes. For example, FIG. 5 shows the pixel electrodes AE disposed in area A1 of FIG. 4 and the emission areas EA where the pixel electrodes AE are disposed.

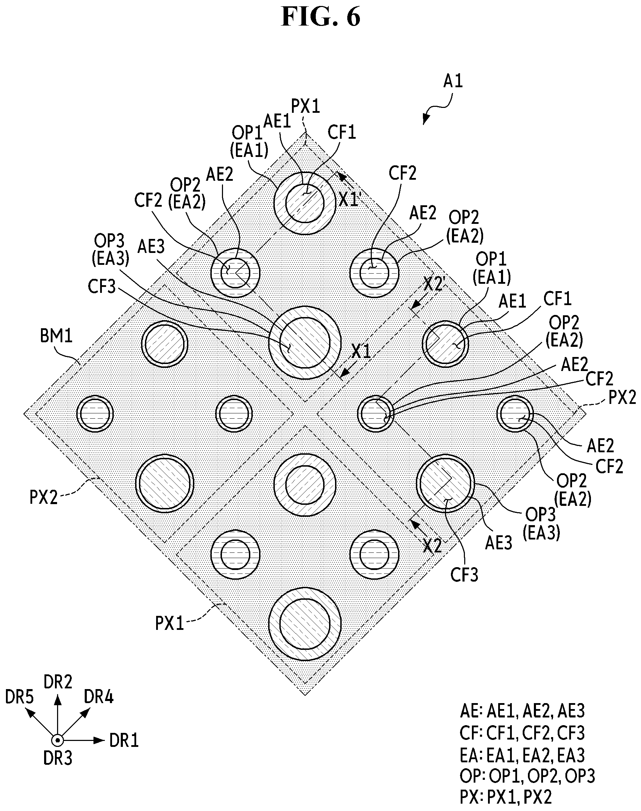

FIG. 6 is a plan view showing pixel electrodes, a first light blocking layer, and color filters. For example, FIG. 6 shows the pixel electrodes AE disposed in area A1 of FIG. 4 and the first light blocking layer BM1 and the color filters CF disposed around the pixel electrodes AE.

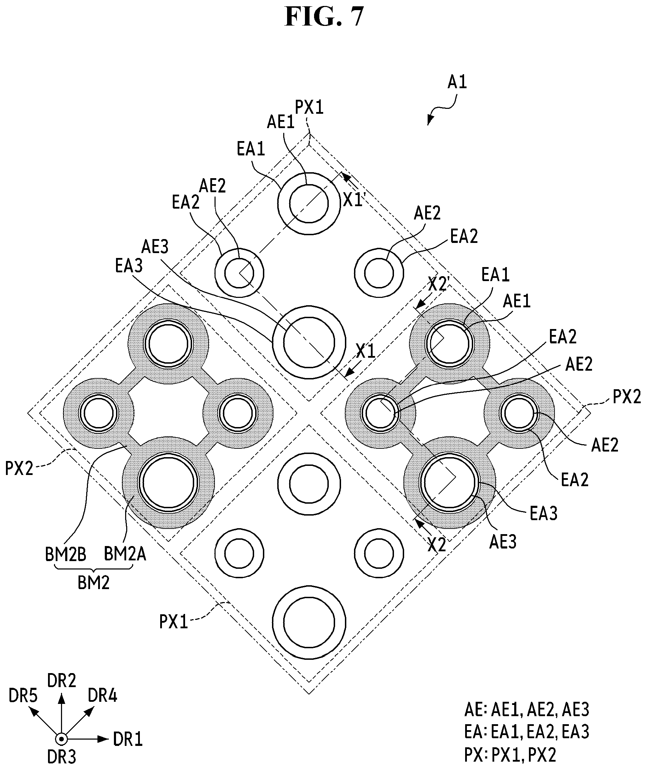

FIG. 7 is a plan view showing pixel electrodes and a second light blocking layer. For example, FIG. 7 shows the pixel electrodes AE disposed in area A1 of FIG. 4 and the second light blocking layer BM2 disposed around the pixel electrodes AE.

Referring to FIGS. 4 to 7, the display device 10 may include the pixels PX disposed in the display area DA. The pixels PX may be arranged in a fourth direction DR4 and a fifth direction DR5 that are between or at angles to the first direction DR1 and the second direction DR2. The fourth direction DR4 and the fifth direction DR5 may be diagonal directions, e.g., at 45° with respect to the first direction DR1 and the second direction DR2.

Each of the pixels PX may include a plurality of pixel electrodes AE. For example, each of the pixels PX may include a first pixel electrode AE1, a second pixel electrode AE2, and a third pixel electrode AE3. One pixel PX may include one first pixel electrode AE1, two second pixel electrodes AE2, and one third pixel electrode AE3. However, they are not limited thereto, and the number of pixel electrodes AE disposed in each pixel PX may be variously changed.

One pixel electrode AE may be a first electrode, e.g., an anode electrode, of a light emitting element in one pixel or sub-pixel. One pixel PX may include a plurality of light emitting elements and a plurality of pixel circuits respectively electrically connected to the plurality of light emitting elements. Each pixel circuit may be electrically connected to at least one light emitting element. Each pixel circuit and at least one light emitting element connected to the pixel circuit may constitute each sub-pixel.

Each pixel electrode AE shown in FIGS. 4 to 7 may be the entire pixel electrode AE, or a part of the pixel electrode AE exposed in an area where the pixel defining film is opened. On each pixel electrode AE, the light emitting layer of the light emitting element including the pixel electrode AE and the second electrode (e.g., common electrode) may be disposed.

One pixel PX may include light emitting elements that emit light of different colors. For example, the light emitting element (e.g., first light emitting element) including the first pixel electrode AE1 may emit light of a first color (e.g., red light). The light emitting element (e.g., second light emitting element) including the second pixel electrode AE2 may emit light of a second color (e.g., green light), and the light emitting element (e.g., third light emitting element) including the third pixel electrode AE3 may emit light of a third color (e.g., blue light). Accordingly, the pixel PX may emit any one of light of the first color, light of the second color, and light of the third color or may emit mixed light including light of at least two of the first color, the second color, and the third color. For example, all the light emitting elements included in one pixel PX emit light, so that light that appears white may be emitted from the pixel PX. However, the type, number, and arrangement the pixel electrodes AE constituting one pixel PX and the light emitting elements including the same may be variously changed.

As shown in FIG. 5, the pixel electrodes AE may be disposed in the emission areas EA of each pixel PX. Each pixel PX may include the plurality of emission areas EA including a first emission area EA1 that emits light of the first color, a second emission area EA2 that emits light of the second color, and a third emission area EA3 that emits light of the third color. One pixel PX may include one first emission area EA1, two second emission areas EA2, and one third emission area EA3, but they are not limited thereto. The first pixel electrode AE1 may be disposed in the first emission area EA1, the second pixel electrode AE2 may be disposed in the second emission area EA2, and the third pixel electrode AE3 may be disposed in the third emission area EA3. Each emission area EA may contain the light emitting elements including the pixel electrodes AE.

Each emission area EA may include an area where each pixel electrode AE overlaps an opening formed in the pixel defining film (e.g., the pixel defining film PDL of FIG. 9). For example, each emission area EA may be primarily defined by the pixel defining film. Further, each emission area EA, which is an area that is not blocked by the first light blocking layer BM1 and the second light blocking layer BM2, may be a light transmitting area through which light generated from the light emitting element including each pixel electrode AE transmits. For example, each emission area EA may correspond to an opening OP in the first light blocking layer BM1.

The arrangement of the pixel electrodes AE may be a Pentile^{™} type, e.g., a diamond Pentile^{™} type. For example, the first pixel electrodes AE1 and the third pixel electrodes AE3 may be spaced apart from each other in the second direction DR2 and may be interleaved or alternately arranged along the first direction DR1 and the second direction DR2. In each pixel PX, the first pixel electrode AE1 and the third pixel electrode AE3 may be spaced apart from each other in the second direction DR2, and the first pixel electrode AE1 and the third pixel electrode AE3 may be spaced apart from the second pixel electrodes AE2 in the fourth direction DR4 or the fifth direction DR5. The second pixel electrodes AE2 may be repeatedly arranged along the first direction DR1 and the second direction DR2. The second pixel electrodes AE2 and the first pixel electrodes AE1, or the second pixel electrodes AE2 and the third pixel electrodes AE3 may be interleaved or alternately arranged along the fourth direction DR4 or the fifth direction DR5. However, the arrangement is not limited thereto, and the arrangement of the pixel electrodes AE may be variously changed.

The sizes (e.g., areas) of the first pixel electrode AE1, the second pixel electrode AE2, and the third pixel electrode AE3 may be different from each other. For example, the area of the third pixel electrode AE3 may be larger than those of the first pixel electrode AE1 and the second pixel electrode AE2, and the area of the first pixel electrode AE1 may be larger than that of the second pixel electrode AE2. The intensity of light emitted from each emission area EA may vary depending on the area of the emission area EA where each pixel electrode AE is disposed. Accordingly, the color of the screen displayed on the display device 10 or the electronic device 1 may be controlled by adjusting the area of each pixel electrode AE and the emission area EA including the same. Although FIGS. 4 to 7 show an example in which the third pixel electrode AE3 has the largest area, it is not limited thereto. For example, the size (e.g., area) of the pixel electrode AE and the emission area EA including the same may be freely adjusted depending on the color of the screen required for the display device 10 or the electronic device 1. In addition, the area of the pixel electrode AE and the emission area EA may be related to light efficiency the associated light emitting element, the lifespan of the light emitting element, or the like, and may have a trade-off relation with the reflection of external light. The area of the pixel electrodes AE may be appropriately adjusted in consideration of the above factors.

As shown in FIG. 6, the emission areas EA of the pixels PX may be surrounded by the first light blocking layer BM1. Further, the color filters CF may be disposed in the emission areas EA of the pixels PX. The color filters CF may be disposed on the light emitting element layer (e.g., the light emitting element layer EML of FIG. 3) including the light emitting elements of the pixels PX.

The first light blocking layer BM1 may cover the display area DA except for the openings OP corresponding to the emission areas EA of the pixels PX. For example, the first light blocking layer BM1 may be disposed in the non-emission area around the emission areas EA and may include the openings OP overlapping the emission areas EA. In a plan view, the first light blocking layer BM1 may include first openings OP1 over the first emission areas EA1, second openings OP2 over the second emission areas EA2, and third openings OP3 over the third emission areas EA3, and may surround the first emission areas EA1, the second emission areas EA2, and the third emission areas EA3. The first light blocking layer BM1 may block the other part (e.g., the non-emission area) of the display area DA except the first emission areas EA1, the second emission areas EA2, and the third emission areas EA3.

The openings OP in the first light blocking layer BM1 may overlap the pixel electrodes AE, or a part of the pixel electrodes AE exposed by the openings in the pixel defining film. The first openings OP1 of the first light blocking layer BM1 may overlap the respective first pixel electrodes AE1. The second openings OP2 of the first light blocking layer BM1 may overlap the respective second pixel electrodes AE2. The third openings OP3 of the first light blocking layer BM1 may overlap the respective third pixel electrodes AE3. In the pixel area where one pixel PX is disposed, one first opening OP1, two second openings OP2, and one third opening OP3 may be formed in the first light blocking layer BM1.

Each of the openings OP in the first light blocking layer BM1 may be larger than each pixel electrode AE (or a part of the pixel electrode AE exposed by the opening of the pixel defining film) in a plan view. For example, the area of the first opening OP1 may be larger than the area of the first pixel electrode AE1, the area of the second opening OP2 may be larger than the area of the second pixel electrode AE2, and the area of the third opening OP3 may be larger than the area of the third pixel electrode AE3 in a plan view. The area of the first opening OP1, the area of the second opening OP2, and the area of the third opening OP3 in the first light blocking layer BM1 may be different from each other. For example, the area of the first opening OP1, the area of the second opening OP2, and the area of the third opening OP3 may respectively correspond to the area of the first pixel electrode AE1, the area of the second pixel electrode AE2, and the area of the third pixel electrode AE3. Further, the sizes (e.g., areas) of the first emission area EA1, the second emission area EA2, and the third emission area EA3 may be different to correspond to the area of the first opening OP1, the area of the second opening OP2, and the area of the third opening OP3 of the light blocking layer BM1.

The display area DA may include at least two types of pixels PX. For example, the display area DA may include first pixels PX1 and second pixels PX2. The light exit angles and/or viewing angles of the first pixels PX1 and the second pixels PX2 may be different. For example, the first pixels PX1 may be the pixels PX that provide a wider range of light exit angles and/or viewing angles, and the second pixels PX2 may be the pixels PX that provide a narrower range of light exit angles and/or viewing angles.

The first pixels PX1 may be driven only in a first emission mode and may be turned off or may not emit light in a second emission mode. The second pixels PX2 may be driven in both the first emission mode and the second emission mode. The first emission mode may be a general mode, e.g., a wide viewing angle mode, in which the viewing angle of the image displayed in the display area DA is not limited, and the second lighting mode may be a side viewing angle blocking mode, e.g., a privacy protection mode or a security mode, in which the viewing angle of the image displayed in the display area DA is limited.

The first pixels PX1 and the second pixels PX2 may be interleaved or alternately arranged along the fourth direction DR4 and the fifth direction DR5. Further, the first pixels PX1 may be repeatedly arranged along the first direction DR1 and the second direction DR2, and the second pixels PX2 may be repeatedly arranged along the first direction DR1 and the second direction DR2. For example, the first pixels PX1 and the second pixels PX2 may be interleaved or alternately arranged and uniformly distributed across the entire display area DA. However, the arrangement is not limited thereto, and the arrangement of the first pixels PX1 and the second pixels PX2 may be variously changed.

The separation distance (or the size of the openings OP in the first light blocking layer BM1 exposing the emission areas EA of the first pixels PX1) between the openings OP the first light blocking layer BM1 and the pixel electrodes AE in the first pixels PX1 may be different from the separation distance (or the size of the openings OP in the first light blocking layer BM1 exposing the emission areas EA of the second pixels PX2) between the openings OP of the first light blocking layer BM1 and the pixel electrodes AE in the second pixels PX2. For example, in a plan view, the separation distance (or the difference between the diameters of the openings OP of the first light blocking layer BM1 and the diameters of the pixel electrodes AE in the first pixels PX1) between the openings OP of the first light blocking layer BM1 and the pixel electrodes AE in the first pixels PX1 may be greater than the separation distance (or the difference between the diameters of the openings OP of the first light blocking layer BM1 and the diameters of the pixel electrodes AE in the second pixels PX2) between the openings OP of the first light blocking layer BM1 and the pixel electrodes AE in the second pixels PX2. For example, a distance from an emission area EA of the second pixels PX2 to an edge of the first light blocking layer BM1 surrounding that emission area EA of the second pixels PX2 may be shorter than a distance from an emission area EA of the first pixels PX1 to an edge of the first light blocking layer BM1 surrounding that emission area EA of the first pixels PX1. Further, the size of the openings OP of the first light blocking layer BM1 exposing the emission areas EA of the first pixels PX1 may be greater than the size of the openings OP of the first light blocking layer BM1 exposing the emission areas EA of the second pixels PX2. Accordingly, the light exit angle of light emitted from the second pixels PX2, or the viewing angle of the image displayed by the second pixels PX2 may be narrower than the angle range in which light is emitted from the first pixels PX1, or the viewing angle of the image displayed by the first pixels PX1. The light exit angle or viewing angle of the second pixels PX2 as well as the size or position of the openings OP of the light blocking layer BM1 may be controlled (e.g., further limited) by the second light blocking layer BM2.

The size (or the aperture ratio of the first pixels PX1) of the emission areas EA of the first pixels PX1 may be greater than the size (or the aperture ratio of the second pixels PX2) of the emission areas EA of the second pixels PX2. For example, since the first light blocking layer BM1 surrounds the emission areas EA where the pixel electrodes AE of the second pixels PX2 are disposed at a shorter distance, the size (e.g., area) of the emission areas EA of the second pixels PX2 may be reduced compared to the size (e.g., area) of the emission areas EA of the first pixels PX1 while still maintaining or reducing the view angle for the second pixels PX2. The areas occupied by each first pixel PX1 and each second pixel PX2 in the display area DA may be substantially the same. Accordingly, the size of the non-emission area of the second pixels PX2 may be greater than the size of the non-emission area of the first pixels PX1.

The color filters CF may be disposed in the respective emission area EA and may be further disposed around the emission areas EA. For example, the color filters CF may cover the pixel electrodes AE disposed in the respective emission areas EA and the light emitting elements including the pixel electrodes AE, and the color filters CF may further extend past the perimeters of the emission areas EA.

The color filters CF may include first color filters CF1 disposed in the first emission areas EA1, second color filters CF2 disposed in the second emission areas EA2, and third color filters CF3 disposed in the third emission areas EA3. The color filters CF may contain a colorant such as a dye or a pigment that absorbs light at wavelengths outside a specific wavelength band. The first color filters CF1 may transmit the light of the first color emitted from the light emitting elements in the first emission areas EA1 and may absorb and/or block light of other colors (e.g., light of the second color and light of the third color). For example, each first color filter CF1 may be a red color filter that selectively transmits only red light emitted from the light emitting element disposed in each first emission area EA1. The second color filters CF2 may transmit the light of the second color emitted from the light emitting elements in the second emission areas EA2 and may absorb and/or block light of other colors (e.g., the light of the first color and the light of the third color). For example, each second color filter CF2 may be a green color filter that selectively transmits only green light emitted from the light emitting element disposed in each second emission area EA2. The third color filters CF3 may transmit the light of the third color emitted from the light emitting elements in the third emission areas EA3 and may absorb and/or block light of other colors (e.g., the light of the first color and the light of the second color). For example, each third color filter CF3 may be a blue color filter that selectively transmits only blue light emitted from the light emitting element disposed in each third emission area EA3.

The color filters CF may be formed as individual patterns corresponding to the respective emission areas EA or may be formed on the entirety of the display area DA. For example, each first color filter CF1 may be part of an individual pattern that covers each first emission area EA1 and the periphery of each first emission area EA1, each second color filter CF2 may be part of an individual pattern that covers each second emission area EA2 and each periphery of the second emission area EA2, and each third color filter CF3 may be part of an individual pattern that covers each third emission area EA3 and the periphery of each third emission area EA3. Alternatively, the first color filter CF1 may cover the display area DA except for where the first color filter CF1 has openings corresponding to the second emission areas EA2 and the third emission areas EA3, the second color filter CF2 may cover the display area DA except for where the second color filter has openings corresponding to the first emission areas EA1 and the third emission areas EA3, and the third color filter CF3 may cover the display area DA except for where the third color filter CF3 has openings corresponding to the first emission areas EA1 and the second emission areas EA2.

The first light blocking layer BM1 may be formed as a light blocking pattern separate from the color filters CF or may be formed as a part of the color filters CF. For example, the display device 10 may include the first light blocking layer BM1 formed as a light blocking pattern separate from the color filters CF, or the first light blocking layer BM1 be formed by overlapping the color filters CF that block light of different colors in the non-emission areas around the emission areas EA.

The first light blocking layer BM1 and the color filters CF may be disposed on the display layer DU. For example, the first light blocking layer BM1 and the color filters CF may be disposed in the color filter layer CFL disposed on the touch sensing layer TSU of FIG. 3. The color filters CF and the first light blocking layer BM1 disposed on the display layer DU may reduce the intensity of reflected external light.

As shown in FIG. 7, the second light blocking layer BM2 may be disposed in some pixels PX among the pixels PX disposed in the display area DA. For example, the second pixels PX2 may include the second light blocking layer BM2. In this example, the second light blocking layer BM2 is not disposed in the first pixels PX1.

The second light blocking layer BM2 may surround the emission areas EA of some pixels PX among the pixels PX. For example, the second light blocking layer BM2 may be disposed in the non-emission area of the second pixels PX2, and the second light blocking layer BM2 may surround the emission areas EA of the second pixels PX2. For example, the second light blocking layer BM2 may surround the first emission areas EA1, the second emission areas EA2, and the third emission areas EA3 of the second pixels PX2.

The second light blocking layer BM2 may be disposed on the first light blocking layer BM1 and the color filters CF. For example, the second light blocking layer BM2 may be disposed in the light blocking member layer PML disposed on the color filter layer CFL of FIG. 3. In a plan view, the second light blocking layer BM2 may overlap a part of the first light blocking layer BM1. For example, the second light blocking layer BM2, which is disposed on a part of the first light blocking layer BM1, may be disposed in a part of the non-emission area (e.g., a part of the non-emission area of each of the second pixels PX2). Since the second light blocking layer BM2 is disposed on or above the color filter layer CFL, the second light blocking layer BM2 may adjust or limit the light exit angle or viewing angle of the second pixels PX2.

The light exit angle or viewing angle of the second pixels PX2 may be adjusted or changed by at least one of the size of the openings OP of the first light blocking layer BM1, the separation distance between and the first light blocking layer BM1 and the pixel electrodes AE of the second pixels PX2, the presence/absence of the second light blocking layer BM2, and the separation distance between the second light blocking layer BM2 and the pixel electrodes AE of the second pixels PX2. For example, the second light blocking layer BM2 on the second pixels PX2 may further reduce the light exit angle or viewing angle of the second pixels PX2.

The second light blocking layer BM2 in each second pixel PX2 may be one pattern or region that is separated from patterns or regions of the second light blocking layer BM2 in other second pixels PX2. In the example of FIG. 7, the second light blocking layer BM2 disposed in one second pixel PX2 may include first portions BM2A surrounding the first emission area EA1, the second emission area EA2, and the third emission area EA3, and second portions BM2B that connect the first portions BM2A. The first portions BM2A of the second light blocking layer BM2 may include respective openings corresponding to the respective emission areas EA and may have a shape (e.g., a ring shape) surrounding the respective emission areas EA. The second portions BM2B of the second light blocking layer BM2 may extend between the first portions BM2A and may be formed integrally with the first portions BM2A. Accordingly, in the process for forming the pixels PX, the second portions BM2B of the second light blocking layer BM2 may help prevent the first portions BM2A from deviating from determined positions or being peeled off, and the second light blocking layer BM2 may be more stably formed.

As described above, the display device 10 may include the first pixels PX1 where the second light blocking layer BM2 is not disposed and the second pixels PX2 where the second light blocking layer BM2 is disposed, and the side visibility of the display device 10 may be adjusted depending on the emission mode. Depending on the viewing angle of the display device 10, patterns (e.g., second light blocking pattern disposed in each second pixel PX2) of the second light blocking layer BM2 may partially cover the pixel electrode AE or may limit the emission of light to angles less than a specific viewing angle. For example, the second light blocking layer BM2 may block the emission areas EA of the second pixels PX from emitting light that a viewer can see from the side of the display device 10.

In a state where the side visibility is not limited, which is the first emission mode of the display device 10, both the first pixels PX1 and the second pixels PX2 may emit light. Since both the first pixels PX1 and the second pixels PX2 emit light in the first emission mode, the display device 10 may provide a wide viewing angle. For example, regardless of the direction from which the display device 10 is viewed, a viewer may see the light emitted from at least the first pixels PX1.

On the other hand, in a state where side visibility is limited, which is the second emission mode of the display device 10, the first pixels PX1 may not emit light, and only the second pixels PX2 may emit light. Since only the second pixels PX2 emit light in the second emission mode, the second light blocking layer BM2 may block the light emitted from the openings OP of the first light blocking layer BM1 at angles greater than a specific viewing angle. Since the first pixels PX1 do not emit light, the image of the display device 10 in the second emission mode may be visually recognized only by the user viewing from the front of the display area DA, and a user viewing from a specific viewing angle or from the side of the display device 10 may not visually recognize the image. Accordingly, the display device 10 may provide a side viewing angle blocking mode, e.g., a privacy protection mode.

In the second emission mode of the display device 10, a light leakage phenomenon of light emitted from the second pixels PX2 may occur depending on a degree to which the second light blocking layer BM2 blocks the pixel electrodes AE of the second pixels PX2. However, in the display device 10, the patterns of the second light blocking layer BM2 may have a shape corresponding to the shape of the pixel electrodes AE and may be disposed to surround the emission areas EA where the pixel electrodes AE are disposed. In the second emission mode, the degree to which the pixel electrodes AE of the second pixels PX2 are blocked may be uniform at all viewing angles when viewing the display device 10, and the light leakage phenomenon of light emitted from the light emitting element including the specific pixel electrode AE may be prevented.

Further, in the display device 10, the light blocking members of the second light blocking layer BM2 are disposed to correspond to the pixel electrodes AE of the second pixels PX2, and thus may be disposed so as not to invade other adjacent pixels, e.g., the first pixels PX1. Accordingly, in the first emission mode, the light blocking members of the second light blocking layer BM2 may not substantially block the light emitted from the emission areas EA of the first pixels PX1.

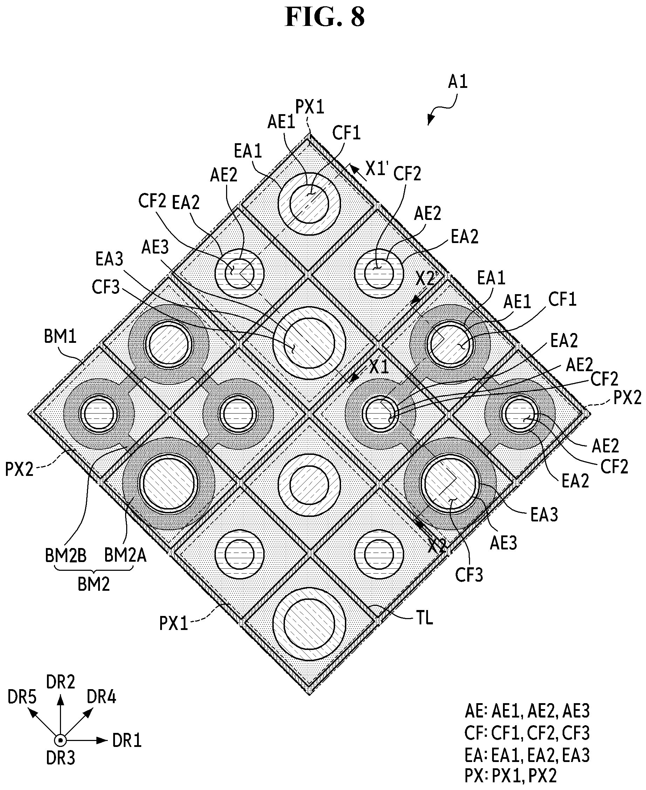

FIG. 8 is a plan view of a display area of a display device. FIG. 8 particularly shows an example in which a touch electrode TL together with the pixel electrodes AE, the first light blocking layer BM1, the color filters CF, and the second light blocking layer BM2 are disposed in area A1 of FIG. 4.

Referring to FIG. 8 and to FIGS. 4 to 7, the display device 10 may further include the touch electrodes TL overlying areas between the pixel electrodes AE. Although FIG. 8 shows the approximate shape of the touch electrode TL disposed in area A1 of FIG. 4, a plurality of touch electrodes TL may be disposed in the display area DA. For example, when the display device 10 includes a mutual capacitance type touch sensor, the plurality of touch electrodes TL including driving electrodes and sensing electrodes may be disposed in the display area DA.

The touch electrodes TL may be formed as mesh-shaped patterns including openings exposing the emission areas EA of the pixels PX. For example, each touch electrode TL or each of a plurality of electrode cells constituting the touch electrode TL may have a mesh-shaped pattern formed of thin lines respectively extending in the fourth direction DR4 or the fifth direction DR5 and overlapping the first light blocking layer BM1.

The resolution of the pixels PX and the resolution of the touch electrodes TL may be different. For example, each touch electrode TL may be disposed in the area where the plurality of pixels PX are disposed. For example, the touch electrode TL shown in FIG. 8 may be one touch electrode TL disposed in area A1 of FIG. 4 or one electrode cell forming the touch electrode TL. The shape, number, resolution, and/or structure of the touch electrodes TL may be variously changed. The touch electrodes TL may be connected or extended in a desired shape or direction through respective bridge patterns.

The touch electrodes TL may be disposed on the display layer DU. For example, the touch electrodes TL may be disposed in the touch sensing layer TSU of FIG. 3. The touch electrodes TL may sense a touch input in the display area DA.

FIG. 9 is a cross-sectional view of a display device. FIG. 9 particularly shows a portion of the display device 10 corresponding to the cross section of one of the first pixels PX1 taken along line X1-X1' of FIGS. 4 to 8.

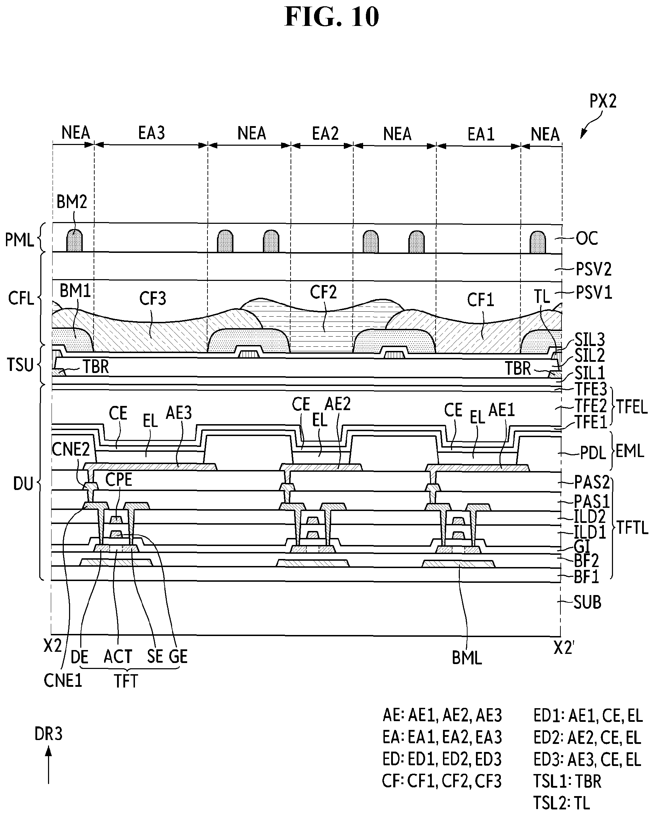

FIG. 10 is a cross-sectional view of a display device. FIG. 10 particularly shows a portion of the display device 10 corresponding to the cross section of one of the second pixels PX2 taken along line X2-X2' of FIGS. 4 to 8.

Referring to FIGS. 9 and 10 and to FIGS. 1 to 8, the display panel 100 of the display device 10 may include the display layer DU, the touch sensing layer TSU, the color filter layer CFL, and the light blocking member layer PML. The display layer DU may include the substrate SUB, the thin film transistor layer TFTL, the light emitting element layer EML, and the encapsulation layer TFEL. The touch sensing layer TSU may include the touch electrodes TL and bridge patterns TBR. The color filter layer CFL may include the first light blocking layer BM1 and the color filters CF. The light blocking member layer PML may include the second light blocking layer BM2.

The substrate SUB may be a base substrate or a base member. The substrate SUB may be a flexible substrate which can be bent, folded or rolled, but is not limited thereto.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2. However, the arrangement is not limited thereto, and the number or type of conductive layers and insulating layers forming the thin film transistor layer TFTL, and/or the structure or type of the thin film transistor TFT may be variously changed.

The first buffer layer BF1 may be disposed on the substrate SUB. The first buffer layer BF1 may include an inorganic film capable of preventing penetration of air or moisture. For example, the first buffer layer BF1 may include a plurality of inorganic films alternately stacked.

The lower metal layer BML may be disposed on the first buffer layer BF1. The lower metal layer BML may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second buffer layer BF2 may cover the first buffer layer BF1 and the lower metal layer BML. The second buffer layer BF2 may include an inorganic film capable of preventing penetration of air or moisture. For example, the second buffer layer BF2 may include a plurality of inorganic films alternately stacked.

The thin film transistor TFT may be disposed on the second buffer layer BF2, and each of the pixel circuits (e.g., pixel circuits of sub-pixels) included in the pixels PX may include one or more transistors that are similar or identical the thin film transistor TFT. FIGS. 9 and 10 show the approximate shape of one thin film transistor TFT (e.g., the thin film transistor TFT electrically connected to the first light emitting element ED1, the second light emitting element ED2, or the third light emitting element ED3) among the thin film transistors that may be in the respective pixel circuits (e.g., pixel circuits of sub-pixels) of the first pixel PX1 and the second pixel PX2. Each thin film transistor TFT shown in FIGS. 9 and 10 may be a switching transistor or a driving transistor in a pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction DR3 and may be insulated from the gate electrode GE by the gate insulating layer GI. A part of the semiconductor layer ACT may be conductive to form the source electrode SE (or source region) and the drain electrode DE (or drain region).

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. For example, the gate insulating layer GI may cover the semiconductor layer ACT and the second buffer layer BF2 and may be disposed between the semiconductor layer ACT and the gate electrode GE. The gate insulating layer GI may include a contact hole through which the first connection electrode CNE1 passes.

The first interlayer insulating layer ILD1 may cover the gate electrode GE and the gate insulating layer GI. The first interlayer insulating layer ILD1 may include a contact hole through which the first connection electrode CNE1 passes. The contact hole in the first interlayer insulating layer ILD1 may be connected to the contact hole in the gate insulating layer GI and a contact hole in the second interlayer insulating layer ILD2.

The capacitor electrode CPE may be disposed on the first interlayer insulating layer ILD1. The capacitor electrode CPE may overlap the gate electrode GE in the thickness direction DR3. The capacitor electrode CPE and the gate electrode GE may form a capacitor having a capacitance. For example, a storage capacitor of each pixel circuit may be formed by the capacitor electrode CPE and the gate electrode GE.

The second interlayer insulating layer ILD2 may cover the capacitor electrode CPE and the first interlayer insulating layer ILD1. The second interlayer insulating layer ILD2 may include a contact hole through which the first connection electrode CNE1 passes. The contact hole in the second interlayer insulating layer ILD2 may be connected to the contact hole in the first interlayer insulating layer ILD1 and the contact hole in the gate insulating layer GI.

The first connection electrode CNE1 may be disposed on the second interlayer insulating layer ILD2. In the illustrated example where the thin film transistor TFT is a drive transistor for a light emitting element, the first connection electrode CNE1 electrically connects the drain electrode DE of the thin film transistor TFT to the second connection electrode CNE2. In other cases (not shown), the first connection electrode CNE1 may electrically connect the source electrode SE of the thin film transistor TFT to the second connection electrode CNE2. The first connection electrode CNE1 may be in contact with and/or connected to the drain electrode DE of the thin film transistor TFT through a contact hole formed in the second interlayer insulating layer ILD2, the first interlayer insulating layer ILD1, and the gate insulating layer GI.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be disposed on the first passivation layer PAS1. The second connection electrode CNE2 may electrically connect the first connection electrode CNE1 to a pixel electrode AE of a light emitting element ED. The second connection electrode CNE2 may be in contact with and/or connected to the first connection electrode CNE1 through a contact hole formed in the first passivation layer PAS1. Further, the second connection electrode CNE2 may be in contact with and/or connected to the pixel electrode AE of the light emitting element ED through a contact hole formed in the second passivation layer PAS2. The thin film transistor layer TFTL may not include the second connection electrode CNE2, and the pixel electrode AE of the light emitting element ED may be directly connected to the first connection electrode CNE1 (or one electrode of the thin film transistor TFT).

The second passivation layer PAS2 may cover the second connection electrode CNE2 and the first passivation layer PAS1. The second passivation layer PAS2 may include a contact hole through which the pixel electrode AE of the light emitting element ED passes. The thin film transistor layer TFTL may not include the second connection electrode CNE2 and the second passivation layer PAS2, and the pixel electrode AE of the light emitting element ED may be disposed on the first passivation layer PAS1.

The light emitting element layer EML may be disposed on the thin film transistor layer TFTL. The light emitting element layer EML may include the light emitting elements ED and the pixel defining film PDL. Each light emitting element ED may include a pixel electrode AE (e.g., the first electrode or the anode electrode of the light emitting element ED), the light emitting layer EL, and the common electrode CE (e.g., the second electrode or the cathode electrode of the light emitting element ED). For example, the first light emitting element ED1 disposed in each first emission area EA1 may include the first pixel electrode AE1, and the light emitting layer EL and the common electrode CE that are sequentially stacked on the first pixel electrode AE1. The second light emitting element ED2 disposed in each second emission area EA2 may include the second pixel electrode AE2, and the light emitting layer EL and the common electrode CE that are sequentially stacked on the second pixel electrode AE2. The third light emitting element ED3 disposed in each third emission area EA3 may include the third pixel electrode AE3, and the light emitting layer EL and the common electrode CE that are sequentially stacked on the third pixel electrode AE3.

The pixel electrodes AE may be disposed on the second passivation layer PAS2. Different pixel electrodes AE may be disposed in the respective emission areas EA corresponding to different openings among the openings in the pixel defining film PDL. For example, the first pixel electrode AE1, the second pixel electrode AE2, and the third pixel electrode AE3 of the first pixel PX1 may be disposed in the first emission area EA1, the second emission area EA2, and the third emission area EA3 of the first pixel PX1, respectively, and the first pixel electrode AE1, the second pixel electrode AE2, and the third pixel electrode AE3 of the second pixel PX2 may be disposed in the first emission area EA1, the second emission area EA2, and the third emission area EA3 of the second pixel PX2, respectively.

Each pixel electrode AE may be electrically connected to one electrode of one of the thin film transistors TFT. For example, the pixel electrode AE may be electrically connected to the drain electrode DE of the thin film transistor TFT through the first connection electrode CNE1 and the second connection electrode CNE2.

The light emitting layer EL may be disposed on the pixel electrode AE. The light emitting layer EL may be an organic light emitting layer made of an organic material, but the light emitting layer EL is not limited thereto.

The light emitting layers EL of the first light emitting element ED1, the second light emitting element ED2, and the third light emitting element ED3 may emit light of different colors. For example, the light emitting layer EL of the first light emitting element ED1 may emit light of the first color, e.g., red light, the light emitting layer EL of the second light emitting element ED2 may emit light of the second color, e.g., green light, and the light emitting layer EL of the third light emitting element ED3 may emit light of the third color, e.g., blue light. However, they are not limited thereto. For example, the light emitting layer EL of the light emitting elements ED may be formed as one common layer entirely disposed on the different pixel electrodes AE and the pixel defining film PDL, and the light emitting layer EL disposed on different pixel electrodes AE may emit light of the same color. In this case, the display device 10 may further include a color adjustment layer (e.g., color conversion layer including wavelength conversion patterns and/or color adjustment layer including the color filters CF) disposed on the light emitting elements ED.

The common electrode CE may be disposed on the light emitting layer EL of each of the light emitting elements ED. The common electrode CE may be formed as one common layer entirely covering the display area DA, and the light emitting elements ED of the pixels PX may share one common electrode CE.

The common electrode CE may receive a common voltage (e.g., second pixel voltage or cathode voltage). When the pixel electrode AE receives the first pixel voltage through the thin film transistor TFT and the common electrode CE receives the common voltage, the light emitting layer EL may emit light with a brightness corresponding to the data voltage for a sub-pixel.

The pixel defining film PDL may include openings corresponding to the emission areas EA and may be disposed on portions of the pixel electrodes AE and the second passivation layer PAS2. The openings in the pixel defining film PDL may define the respective emission areas EA, and may partially expose the pixel electrodes AE in the emission areas EA. The pixel defining film PDL may overlap the first light blocking layer BM1 and the second light blocking layer BM2 in a plan view.

The respective portions of the light emitting layer EL may be disposed on the exposed portions of the pixel electrodes AE. Accordingly, each light emitting element ED may be disposed and/or formed in each emission area EA. The openings in the pixel defining film PDL may be of different sizes to define different sizes of the first emission area EA1, the second emission area EA2, and the third emission area EA3.

The pixel defining film PDL may include a light absorbing material to prevent light reflection. For example, the pixel defining film PDL may include a polyimide (PI)-based binder in which red, green, and blue pigments are mixed. Alternatively, the pixel defining film PDL may include a cardo-based binder resin and a mixture of a lactam black pigment and a blue pigment. Alternatively, the pixel defining film PDL may include carbon black.

The encapsulation layer TFEL may be disposed on the common electrode CE to cover the light emitting elements ED. The encapsulation layer TFEL may include at least one inorganic film to prevent oxygen or moisture from penetrating into the light emitting element layer EML. The encapsulation layer TFEL may include at least one organic film to protect the light emitting element layer EML from foreign matters such as dust.

The encapsulation layer TFEL may include a first encapsulation layer TFE1, a second encapsulation layer TFE2, and a third encapsulation layer TFE3 that are sequentially disposed on the light emitting elements ED. The first encapsulation layer TFE1 and the third encapsulation layer TFE3 may be inorganic encapsulation layers, and the second encapsulation layer TFE2 disposed between the first encapsulation layer TFE1 and the third encapsulation layer TFE3 may be an organic encapsulation layer.

Each of the first encapsulation layer TFE1 and the third encapsulation layer TFE3 may include an inorganic insulating material. For example, each of the first encapsulation layer TFE1 and the third encapsulation layer TFE3 may include aluminum oxide, titanium oxide, tantalum oxide, hafnium oxide, zinc oxide, silicon oxide, silicon nitride, silicon oxynitride and/or another inorganic insulating material.

The second encapsulation layer TFE2 may include an organic insulating material. For example, the second encapsulation layer TFE2 may include a polymer-based organic insulating material such as acrylic resin, epoxy resin, polyimide, or polyethylene, or may include another organic insulating material. The second encapsulation layer TFE2 may be formed by curing a monomer or applying a polymer.

The touch sensing layer TSU may be disposed on the encapsulation layer TFEL. The touch sensing layer TSU may include a first insulating layer SIL1, a second insulating layer SIL2, the touch electrode TL, and a third insulating layer SIL3. Further, the touch sensing layer TSU may include conductive patterns including the touch electrode TL. The conductive patterns may be sensing patterns used for sensing a touch input. For example, the conductive patterns may be utilized to detect a touch input through sensing of a change in electrical characteristics (e.g., change in capacitance) that the touch input causes.

The conductive patterns of the touch sensing layer TSU may further include the bridge patterns TBR for connecting the touch electrodes TL or electrode cells forming the touch electrodes TL. Each bridge pattern TBR may be electrically connected to at least one touch electrode TL and may overlap a part (e.g., two electrode cells included in the touch electrode TL and adjacent to each other) of at least one touch electrode TL.

The conductive patterns of the touch sensing layer TSU may be disposed in the non-emission area NEA around the emission areas EA and may be covered with the first light blocking layer BM1. Accordingly, the user may not be able to see or visually recognize the conductive patterns of the touch sensing layer TSU .

The touch sensing layer TSU may include a plurality of conductive layers. For example, the touch sensing layer TSU may include a first conductive layer TSL1 including the bridge patterns TBR and a second conductive layer TSL2 including the touch electrodes TL. At least one insulating layer may be disposed between the first conductive layer TSL1 and the second conductive layer TSL2. For example, the second insulating layer SIL2 may be disposed between the first conductive layer TSL1 and the second conductive layer TSL2. The first conductive layer TSL1 and the second conductive layer TSL2 may be sequentially disposed on the first insulating layer SIL1 (or the encapsulation layer TFEL). For example, the first conductive layer TSL1, the second insulating layer SIL2, and the second conductive layer TSL2 may be sequentially stacked on the first insulating layer SIL1.

The first insulating layer SIL1 may be disposed on the encapsulation layer TFEL. The first insulating layer SIL1 may have an insulating function and an optical function. The first insulating layer SIL1 may include at least one inorganic film. Optionally, the first insulating layer SIL1 may be omitted.

The bridge pattern TBR may be disposed on the first insulating layer SIL1. The position of the bridge pattern TBR may vary. For example, the touch electrode TL and the bridge pattern TBR may be disposed in different layers of the touch sensing layer TSU, and the positions of the touch electrode TL and the bridge pattern TBR may be reversed. For example, the touch electrode TL may be disposed or included in the first conductive layer TSL1 on the first insulating layer SIL1, and the bridge pattern TBR may be disposed or included in the second conductive layer TSL2 on the second insulating layer SIL2.

The second insulating layer SIL2 may be disposed on the bridge pattern TBR. For example, the second insulating layer SIL2 may cover the bridge pattern TBR and the first insulating layer SIL1 and may be disposed between the touch electrode TL and the bridge pattern TBR. The second insulating layer SIL2 may include a contact hole through which the touch electrode TL (or the bridge pattern TBR) passes at a portion where the touch electrode TL and the bridge pattern TBR are connected.

The second insulating layer SIL2 may have an insulating function and an optical function. The second insulating layer SIL2 may be an inorganic film containing at least one of a silicon nitride layer, a silicon oxynitride layer, a silicon oxide layer, a titanium oxide layer, or an aluminum oxide layer.

The touch electrode TL (or a part of the touch electrodes TL in the display area DA) may be disposed on the second insulating layer SIL2. The touch electrode TL may include a conductive material and may be formed as a single layer or multiple layers. For example, the touch electrode TL may be formed as a single layer containing molybdenum (Mo), titanium (Ti), copper (Cu), aluminum (Al), or indium tin oxide (ITO), or may be formed to have a stacked structure (Ti/Al/Ti) of aluminum and titanium, a stacked structure (ITO/AI/ITO) of aluminum and ITO, an Ag-Pd-Cu (APC) alloy, or a stacked structure (ITO/APC/ITO) of APC alloy and ITO.

The touch electrode TL may not overlap the pixel electrodes AE. For example, the touch electrode TL may be disposed in the non-emission area NEA located around the emission areas EA. The touch electrode TL may overlap the pixel defining film PDL and the first light blocking layer BM1.

The first light blocking layer BM1 may have a width enough to completely cover the touch electrode TL, and the edge of the first light blocking layer BM1 may be some distance away from the touch electrode TL. The line width of the thin lines forming the touch electrode TL may be within a range of 4 µm to 6 µm, and the distance between the touch electrode TL and the edge of the first light blocking layer BM1 may be within a range of 5 µm to 7 µm. The touch electrode TL may be disposed such that the center thereof is substantially side by side with the center of the first light blocking layer BM1, and the distance from both sides of the touch electrode TL to the edge of the first light blocking layer BM1 may be substantially constant.

The third insulating layer SIL3 may be disposed on the touch electrode TL. For example, the third insulating layer SIL3 may cover the touch electrode TL and the second insulating layer SIL2. The third insulating layer SIL3 may have an insulating function and an optical function. The third insulating layer SIL3 may include a material exemplified by the material described above for the second insulating layer SIL2.

The color filter layer CFL may be disposed on the touch sensing layer TSU. The color filter layer CFL may include the first light blocking layer BM1, the color filters CF, and at least one passivation layer. For example, the color filter layer CFL may include the first light blocking layer BM1, the color filters CF, the first passivation layer PSV1, and the second passivation layer PSV2.

The first light blocking layer BM1 may be disposed on the touch sensing layer TSU. The first light blocking layer BM1 may cover the touch electrode TL and may include the openings OP exposing the pixel electrodes AE. For example, each opening OP1 in the first light blocking layer BM1 may be disposed in a corresponding first emission area EA1 to expose the first pixel electrode AE1, each second opening OP2 may be disposed in a corresponding second emission area EA2 to expose the second pixel electrode AE2, and each third opening OP3 may be disposed in a corresponding third emission area EA3 to expose the third pixel electrode AE3. The first light blocking layer BM1 may include a light blocking material (e.g., a light absorbing material) such as a black matrix material.

Openings OP in the first light blocking layer BM1 may have different sizes in the first pixels PX1 and the second pixels PX2. For example, the areas (or widths) of the first opening OP1, the second opening OP2, and the third opening OP3 that are respectively disposed in the first emission area EA1, the second emission area EA2, and the third emission area EA3 of each first pixel PX1 may be greater than the respective areas (or widths) of the first opening OP1, the second opening OP2, and the third opening OP3 that are respectively disposed in the first emission area EA1, the second emission area EA2, and the third emission area EA3 of each second pixel PX2.

The color filters CF may be disposed on the touch sensing layer TSU and the first light blocking layer BM1. The color filters CF may be disposed in the respective emission areas EA and overlap the respective light emitting elements ED. The color filters CF may also be disposed around the respective emission areas EA, and at least two adjacent color filters CF may overlap each other between the emission areas EA .

The first color filter CF1 may be disposed in the first emission area EA1 and overlap the first light emitting element ED1. An edge portion of the first color filter CF1 may be disposed around the first emission area EA1 and overlap a part of the first light blocking layer BM1. For example, in a plan view, the edge portion of the first color filter CF1 may surround the first emission area EA1 and may be disposed on a part of the first light blocking layer BM1.

The second color filter CF2 may be disposed in the second emission area EA2 and overlap the second light emitting element ED2. An edge portion of the second color filter CF2 may be disposed around the second emission area EA2 and overlap a part of the first light blocking layer BM1. For example, in a plan view, the edge portion of the second color filter CF2 may surround the second emission area EA2 and may be disposed on a part of the first light blocking layer BM1.

The third color filter CF3 may be disposed in the third emission area EA3 and overlap the third light emitting element ED3. An edge portion of the third color filter CF3 may be disposed around the third emission area EA3 and overlap a part of the first light blocking layer BM1. For example, in a plan view, the edge portion of the third color filter CF3 may surround the third emission area EA3 and may be disposed on a part of the first light blocking layer BM1.

The first passivation layer PSV1 and the second passivation layer PSV2 may be sequentially stacked on the first light blocking layer BM1 and the color filters CFL. The first passivation layer PSV1 and the second passivation layer PSV2 may entirely cover the display area DA, thereby flattening the stepped portions or surface contours caused by the color filters CF and the first light blocking layer BM1.

The first passivation layer PSV1 and the second passivation layer PSV2 may be light transmissive layers. For example, the first passivation layer PSV1 and the second passivation layer PSV2 may include a colorless light transmissive organic material such as an acrylic resin.

The light blocking member layer PML may be disposed on the color filter layer CFL. The light blocking member layer PML may include the second light blocking layer BM2 and an overcoat layer OC.

The second light blocking layer BM2 may be disposed on the color filter layer CFL. The second light blocking layer BM2 may include a light blocking material such as a black matrix material. The material of the first light blocking layer BM1 and the material of the second light blocking layer BM2 may be the same or different.

The second light blocking layer BM2 may not be disposed in or overlie the first pixels PX1 and may be disposed only in or over the second pixels PX2. The second light blocking layer BM2 may surround the emission areas EA of the second pixels PX2 in a plan view. Openings in the second light blocking layer BM2 may be wider than the openings OP in the first light blocking layer BM1, but the present disclosure is not limited thereto. The size, shape, and/or position of the second light blocking layer BM2 may be adjusted or changed depending on the target viewing angle range for the second pixels PX2.

The overcoat layer OC may be disposed on the second light blocking layer BM2. The overcoat layer OC may cover the color filter layer CFL and the second light blocking layer BM2.

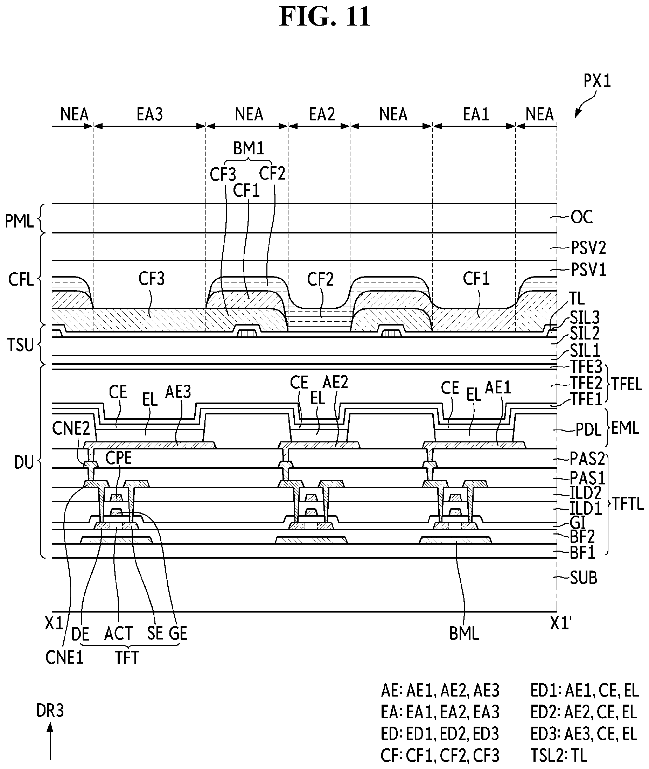

FIG. 11 is a cross-sectional view of a portion of a display device. For example, FIG. 11 shows a portion of the display device 10 corresponding to the cross section of the first pixel PX1 taken along line X1-X1' of FIGS. 4 to 8.

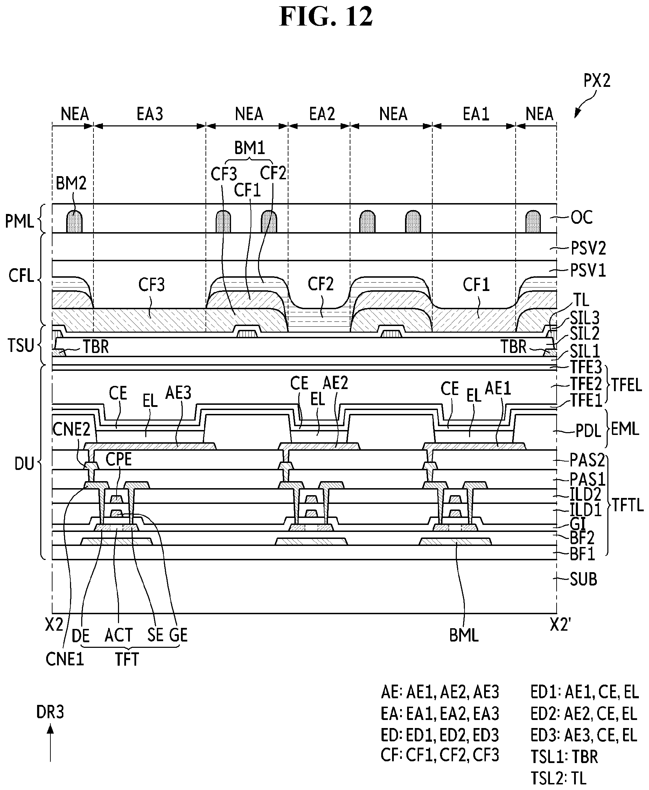

FIG. 12 is a cross-sectional view of a portion of a display device. For example, FIG. 12 shows a portion of the display device 10 corresponding to the cross section of the second pixel PX2 taken along line X2-X2' of FIGS. 4 to 8.

FIGS. 11 and 12 show an embodiment different from the embodiment of FIGS. 9 and 10 in relation to the first light blocking layer BM1. In describing the following embodiments, components substantially identical or similar to those of at least one embodiment described above are designated with the same reference numerals used above, and redundant descriptions of such components may be omitted. Further, each embodiment may be applied alone or in combination with at least one other embodiment, and all possible combinations of embodiments may fall within the scope of the present disclosure.

Referring to FIGS. 11 and 12 in addition to FIGS. 1 to 10, the first light blocking layer BM1 in the display device 10 shown in FIGS. 11 and 12 may be formed by overlapping the color filters CF of different colors. For example, the display device 10 may not include a separate first light blocking layer BM1, e.g., the first light blocking layer BM1 of FIGS. 9 and 10, that is formed separately from the color filters CF and includes a light blocking material. The display device 10 may include, instead of the first light blocking layer BM1 of FIGS. 9 and 10, the first light blocking layer BM1 including the color filters CF arranged to overlap each other in the non-emission area NEA around the emission areas EA. The non-emission area NEA may be the area of the display area DA except for the emission areas EA. For example, the non-emission area NEA may be located around the emission areas EA and may be disposed at the periphery of each of the emission areas EA and between the emission areas EA.

The first light blocking layer BM1 of FIG. 11 and 12 may include regions where the first color filter CF1, the second color filter CF2, and the third color filter CF3 overlap each other in the non-emission area NEA. For example, the first color filter CF1 may be disposed in the non-emission area NEA and the first emission areas EA1 of the pixels PX, the second color filter CF2 may be disposed in the non-emission area NEA and the second emission areas EA2 of the pixels PX, and the third color filter CF3 may be disposed in the non-emission area NEA and the third emission areas EA3 of the pixels PX. The first light blocking layer BM1 may include portions of the first color filter CF1, the second color filter CF2, and the third color filter CF3 that overlap. For example, in the non-emission area NEA, the first color filter CF1, the second color filter CF2, and the third color filter CF3 may overlap in the thickness direction (e.g., the third direction DR3) of the display panel 100 to form the first light blocking layer BM1.

Among the first color filter CF1, the second color filter CF2, and the third color filter CF3, the third color filter CF3 may form the lowermost portion, and the second color filter CF2 may form the uppermost portion of the first light blocking area BM1. For example, the color filters CF of the color filter layer CFL may be sequentially arranged or formed on the touch sensing layer TSU in the order of the third color filter CF3, the first color filter CF1, and the second color filter CF2. However, the order is not limited thereto, and the arrangement order of the color filters CF may vary. For example, the color filters CF may be arranged or formed in the order of the first color filter CF1, the third color filter CF3, and the second color filter CF2.

Among the combinations of the color filters CF, the combination of the color filters CF with higher light blocking effect (e.g., light blocking rate for visible light emitted from the pixels PX) may be disposed at the lower part of the light blocking layer BM1. For example, the first color filter CF1 and the third color filter CF3, which selectively transmit red light and blue light, respectively, and absorb or block light of other colors, may be disposed under the second color filter CF2. Accordingly, the first light blocking layer BM1 with an excellent light blocking effect may be formed using the color filters CF without forming a separate light blocking pattern.

The process of forming the first light blocking layer BM1 using a separate light blocking material may be omitted, and the first light blocking layer BM1 may be formed using the color filters CF in the non-emission area NEA. Accordingly, the manufacturing efficiency of the display device 10 may be increased. For example, a separate mask process for forming the first light blocking layer BM1 may be omitted, and the manufacturing process of the display device 10 may be simplified or streamlined.

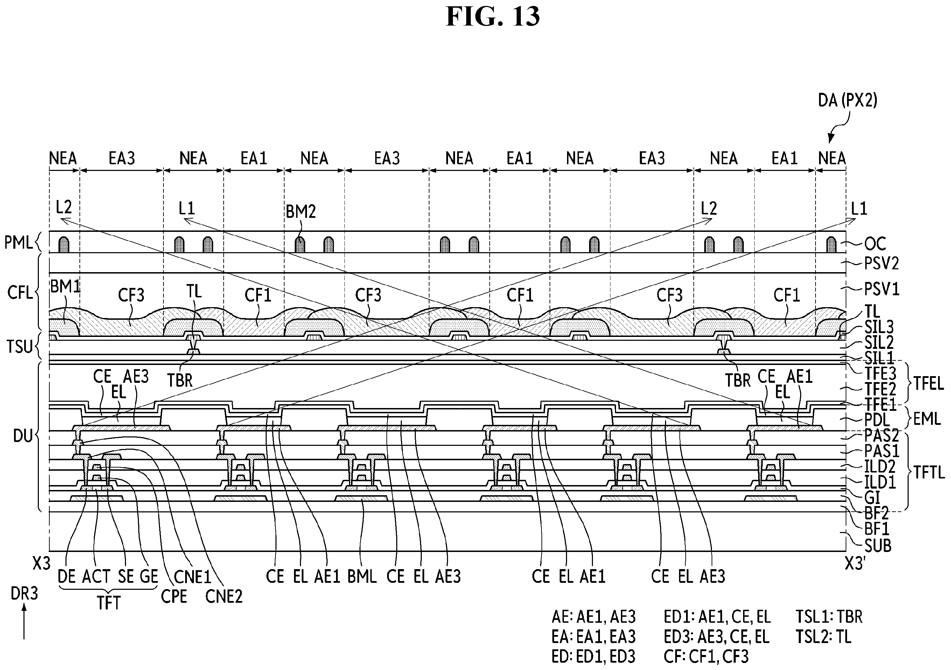

FIG. 13 is a cross-sectional view of a display device. For example, FIG. 13 shows a portion of the display device 10 corresponding to the cross section of the second pixels PX2 taken along line X3-X3' of FIG. 4.

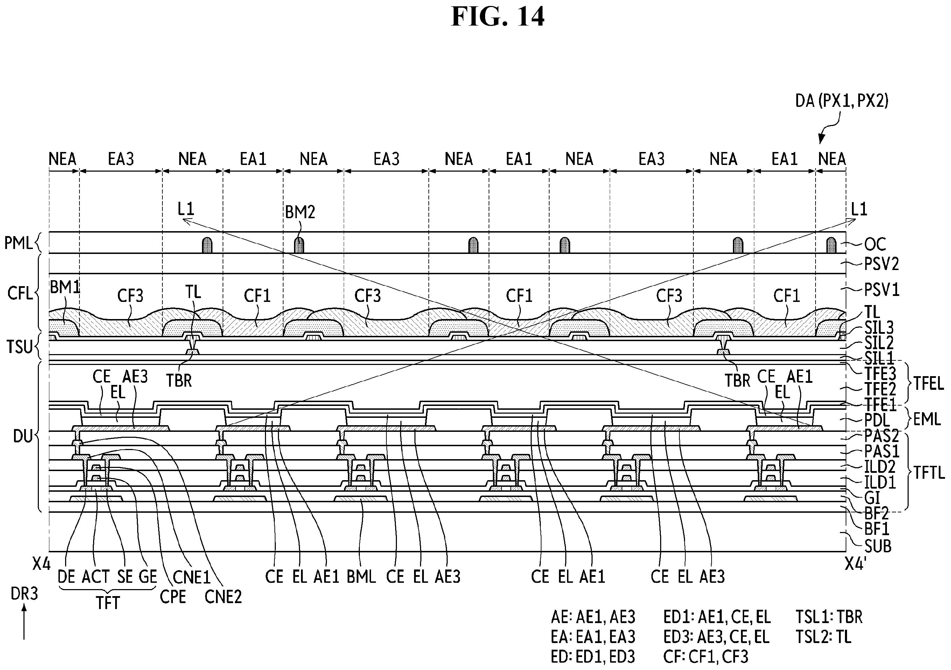

FIG. 14 is a cross-sectional view of a display device. For example, FIG. 14 shows a portion of the display device 10 corresponding to the cross section of the first pixels PX1 and the second pixels PX2 taken along line X4-X4' of FIG. 4.

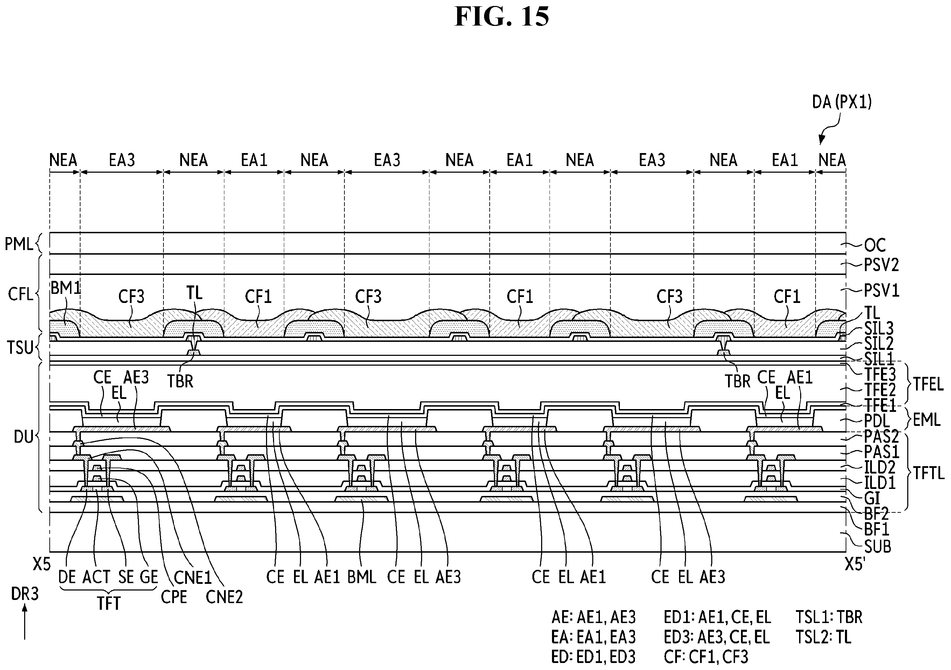

FIG. 15 is a cross-sectional view of a display device. For example, FIG. 15 shows a portion of the display device 10 corresponding to the cross section of the first pixels PX1 taken along line X5-X5' of FIG. 4.

FIGS. 13 to 15 show a portion of the display device 10 including the first light blocking layer BM1 formed separately from the color filters CF. However, the arrangement is not limited thereto. For example, the first light blocking layer BM1 may be formed separately from the color filters CF, or may be formed by stacking the color filters CF.

Referring to FIGS. 13 to 15 in addition to FIGS. 4 to 12, the first light blocking layer BM1 and the second light blocking layer BM2 may be disposed on the display layer DU including the light emitting elements ED. The first light blocking layer BM1 and the second light blocking layer BM2 may be disposed in the non-emission area NEA around the emission areas EA. The first light blocking layer BM1 may surround the emission areas EA of the first pixels PX1 and the second pixels PX2, and the second light blocking layer BM2 may surround the emission areas EA of the second pixels PX2.

Among the light emitted from the light emitting elements ED of the pixels PX, the first light blocking layer BM1 may transmit light traveling within a viewing angle range relative to the front direction, e.g., relative the third direction DR3, and the first light blocking layer BM1 may block side light directed toward the non-emission area NEA. The second light blocking layer BM2 may additionally block the side light emitted at angles in a specific range among the light emitted from the light emitting elements ED of the second pixels PX2. Accordingly, the side viewing angle of the second pixels PX2 may be further limited.

Some of the side light emitted from the pixels PX may not pass through the first light blocking layer BM1 and the second light blocking layer BM2 but may pass through the emission area EA of another adjacent pixel PX to be emitted to the outside of the display device 10. Accordingly, light leakage of side light may occur. For example, among the light of the first color emitted from the first light emitting elements ED1 of the second pixels PX2, first light L1 emitted at a large angle from the front direction travels at an elevation angle in a lateral direction and may be emitted to the outside of the display device 10 by passing through the first color filter CF1 of the adjacent pixel PX without encountering the first light blocking layer BM1 or the second light blocking layer BM2. Similarly, among the light of the third color emitted from the third light emitting elements ED3 of the second pixels PX2, second light L2 emitted at a large angle from the front direction travels at an elevation angle in the lateral direction and may be emitted to the outside of the display device 10 through the third color filter CF3 of the adjacent pixel PX without encountering the first light blocking layer BM1 or the second light blocking layer BM2. Similarly, among the light of the second color emitted from the second light emitting elements ED2 of the second pixels PX2, light emitted at a large angle from the front direction travels at an elevation angle in the lateral direction and may be emitted to the outside of the display device 10 through the second color filter CF2 of the adjacent pixel PX (or adjacent sub-pixel) without encountering the first light blocking layer BM1 and the second light blocking layer BM2.

The light leakage of the side light may occur as described above since a part of the side light emitted from the light emitting elements ED of the second pixels PX2 may be emitted to the outside of the display device 10 without being appropriately absorbed or blocked by the first light blocking layer BM1 and the second light blocking layer BM2. For example, even in the second emission mode in which only the second pixels PX2 are driven and the side viewing angle is limited, a part of the side light emitted from the second pixels PX2 may pass through the non-emission area NEA around the corresponding emission area EA and leak to the outside of the display device 10. Due to the light leakage of the side light, the side viewing angle limiting effect in the second emission mode may be reduced, or the image quality of the display device 10 may deteriorate.

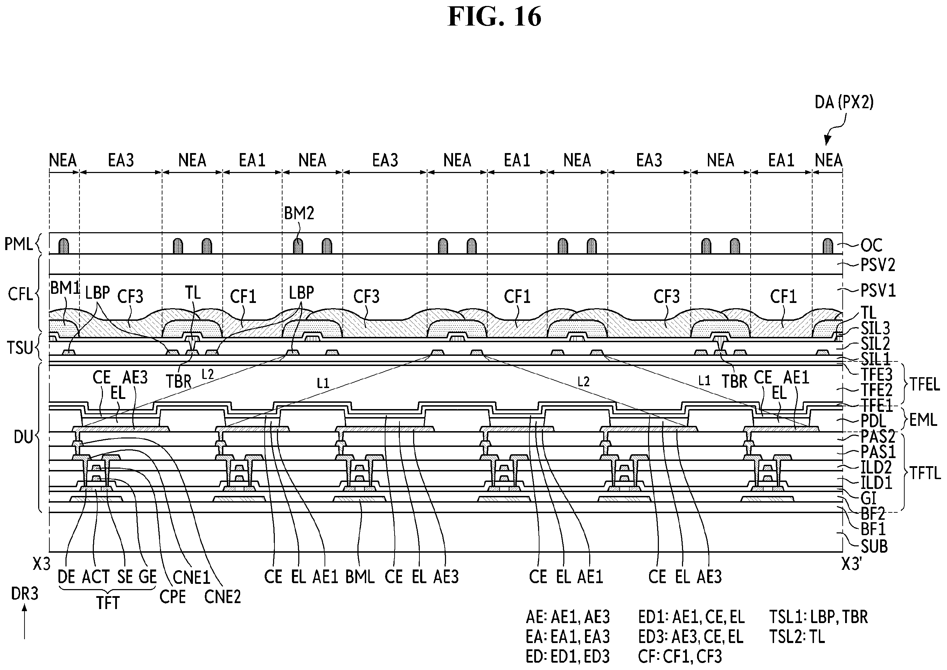

FIG. 16 is a cross-sectional view of a display device. FIG. 16 particularly shows a portion of the display device 10 corresponding to the cross section of the second pixels PX2 taken along line X3-X3' of FIG. 4.

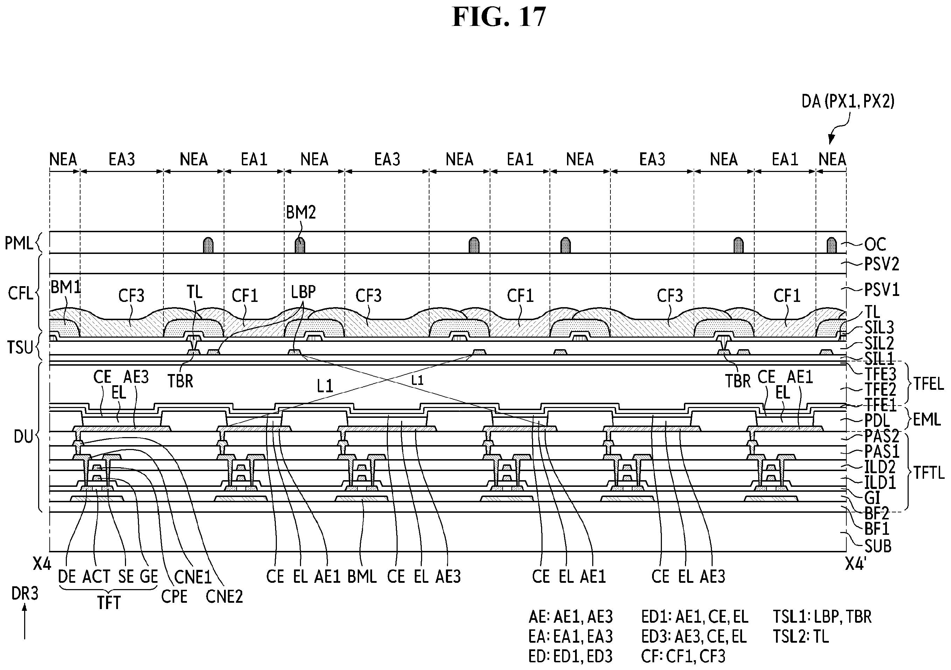

FIG. 17 is a cross-sectional view of a display device. FIG. 17 particularly shows a portion of the display device 10 corresponding to the cross section of the first pixels PX1 and the second pixels PX2 taken along line X4-X4' of FIG. 4.

FIGS. 16 and 17 show an example in which the touch sensing layer TSU differs from the touch sensing layer TSU of FIGS. 13 and 14.

Referring to FIGS. 16 and 17, the touch sensing layer TSU may further include a light blocking pattern LBP disposed in the non-emission area NEA. For example, the touch sensing layer TSU may include the light blocking pattern LBP that is substantially one pattern in a plan view or may include a plurality of light blocking patterns LBP separated from each other.

The light blocking pattern LBP may be disposed in the non-emission area NEA and may overlap the first light blocking layer BM1. For example, the first light blocking layer BM1 disposed on the touch sensing layer TSU may cover the light blocking pattern LBP.

The light blocking pattern LBP may be disposed only in some pixels PX and may surround the emission areas EA of those pixels PX. For example, the light blocking pattern LBP may be disposed only in the second pixels PX2 driven in the second emission mode in which the side viewing angle is limited. The light blocking pattern LBP may be disposed in the non-emission area NEA of the second pixels PX2 and may surround the emission areas EA of the second pixels PX2.

The light blocking pattern LBP may not be disposed in the first pixels PX1 that are driven only in the first emission mode and are not driven in the second emission mode. Accordingly, the side viewing angle of the first pixels PX1 may not be narrowed. Since the light blocking pattern LBP is not disposed in the first pixels PX1 also in the display device 10 including the light blocking pattern LBP as in FIGS. 16 and 17, the cross section of the first pixels PX1 may be substantially the same as or similar to the cross section shown in FIG. 15.

The light blocking pattern LBP may be disposed in the same layer as at least one conductive pattern among the conductive patterns of the touch sensing layer TSU and may be formed simultaneously with the at least one conductive pattern. For example, one of the touch electrode TL and the bridge pattern TBR may be disposed in the same layer as the light blocking pattern LBP and may include the same material as the light blocking pattern LBP. Further, the light blocking pattern LBP may include an opaque material (e.g., metal) that blocks light. Accordingly, the light blocking pattern LBP may be formed in the second pixels PX2 in the process of forming the conductive patterns of the touch sensing layer TSU without adding a separate process for forming the light blocking pattern LBP.

The light blocking pattern LBP may be disposed in the first conductive layer TSL1 of the touch sensing layer TSU. For example, the first conductive layer TSL1 may include the bridge pattern TBR and the light blocking pattern LBP. Since the light blocking pattern LBP is disposed in the first conductive layer TSL1, the light blocking pattern LBP may be disposed closer to the light emitting elements ED of the second pixels PX2 than the touch electrode TL and the first light blocking layer BM1. For example, compared to the touch electrode TL and the first light blocking layer BM1, the light blocking pattern LBP may be disposed at a low height closer to the light emitting element layer EML.

The light blocking pattern LBP may be separated from the conductive patterns for sensing a touch input. For example, the light blocking pattern LBP may be a separation type pattern spaced apart from the bridge pattern TBR and the touch electrode TL.

The light blocking pattern LBP may be disposed closer to the emission areas EA of the second pixels PX2 than the conductive patterns for sensing a touch input. For example, in a plan view, the light blocking pattern LBP may be located at a distance closer to the emission areas EA of the second pixels PX2 than the touch electrode TL and the bridge pattern TBR.

Since the light blocking pattern LBP is disposed close to the light emitting elements ED of the second pixels PX2, the side light emitted from the light emitting elements ED of the second pixels PX2 may be effectively blocked. For example, among the light of the first color emitted from the first light emitting elements ED1 of the second pixels PX2, the first light L1 traveling at an elevation angle in the lateral direction may be blocked by the light blocking pattern LBP disposed in the non-emission area NEA of the adjacent second pixels PX2. Similarly, the light blocking pattern LBP disposed in the non-emission area NEA of the second pixels PX2 may block the light traveling at an elevation angle in the lateral direction among the light of the second color emitted from the second light emitting elements ED2 of the second pixels PX2 and block the second light L2 traveling at an elevation angle in the lateral direction among the light of the third color emitted from the third light emitting element ED3 of the second pixels PX2. Accordingly, light leakage of side light emitted from the second pixels PX2 may be effectively reduced or prevented.

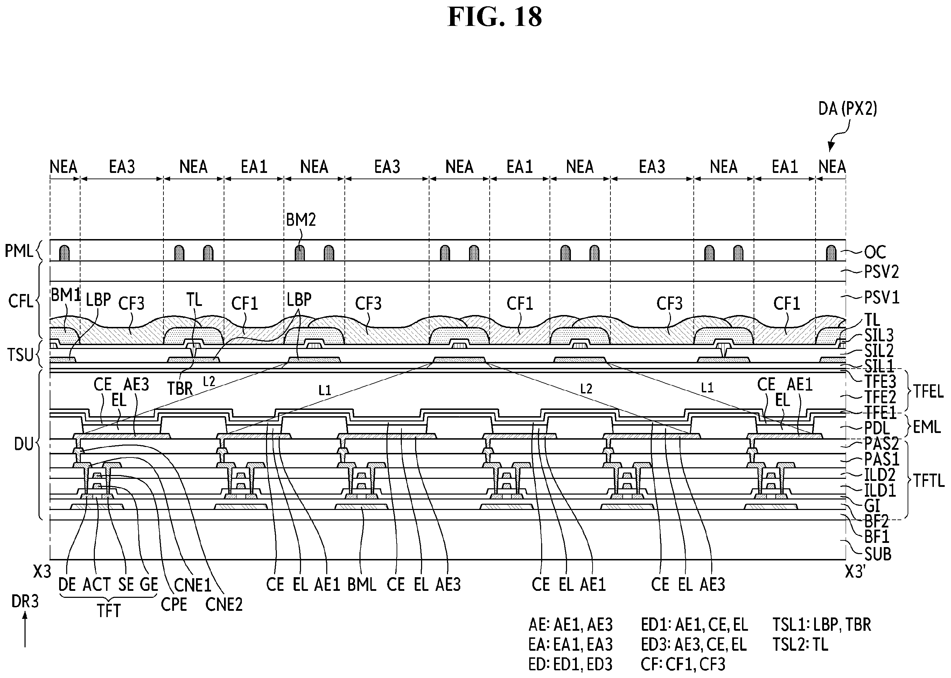

FIG. 18 is a cross-sectional view of a display device. FIG. 18 particularly shows a portion of the display device 10 corresponding to the cross section of the second pixels PX2 taken along line X3-X3' of FIG. 4.

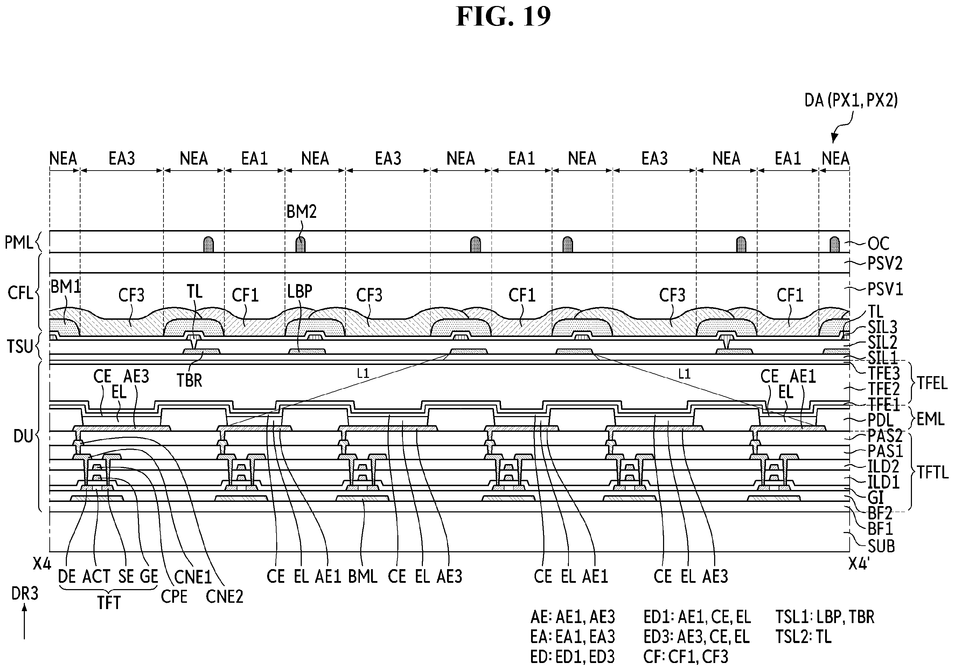

FIG. 19 is a cross-sectional view of a display device. FIG. 19 particularly shows a portion of the display device 10 corresponding to the cross section of the first pixels PX1 and the second pixels PX2 taken along line X4-X4' of FIG. 4.

FIGS. 18 and 19 show an example of the light blocking pattern LBP of the touch sensing layer TSU that differs from FIGS. 16 and 17.

Referring to FIGS. 18 and 19, the light blocking pattern LBP may have a wider width within a range that remains within the non-emission area NEA. For example, the light blocking pattern LBP may be disposed closer in a plan view to the light emitting elements ED of the second pixels PX2 than does the touch electrode TL and may extend to an area closer to the touch electrode TL or may overlap the touch electrode TL. For example, the light blocking pattern LBP may have a width in a plan view greater than that of the touch electrode TL and may overlap the touch electrode TL.

The light blocking pattern LBP (or at least one of light blocking patterns LBP) may be integrated with the bridge pattern TBR. For example, at least one light blocking pattern LBP may be formed integrally with at least one bridge pattern TBR disposed in the non-emission area NEA of the second pixels PX2. For example, the bridge pattern TBR disposed in the non-emission area NEA of the second pixel PX2 may have an extended width to be closer to at least one emission area EA disposed in the second pixel PX2 and function as the light blocking pattern LBP.

The touch sensing layer TSU may include the plurality of light blocking patterns LBP separated from each other, and some of the light blocking patterns LBP may be formed integrally with at least one bridge pattern TBR. Some of the light blocking patterns LBP may be separated from the bridge pattern TBR.

The light blocking pattern LBP may be disposed so as not to impair the electrical stability of the conductive patterns including the touch electrode TL and the bridge pattern TBR. For example, the light blocking pattern LBP may be appropriately separated and disposed in the display area DA to prevent short-circuit defects between the touch electrodes TL disposed in the display area DA. For example, the light blocking pattern LBP may be cut off or not disposed where the light blocking pattern LBP might cause short-circuit defects between the touch electrodes TL.

Since the width of the light blocking pattern LBP and/or the bridge pattern TBR is extended, the blocking rate of side light emitted from the light emitting elements ED of the second pixels PX2 may be further increased. Accordingly, light leakage of side light emitted from the second pixels PX2 may be more effectively prevented.

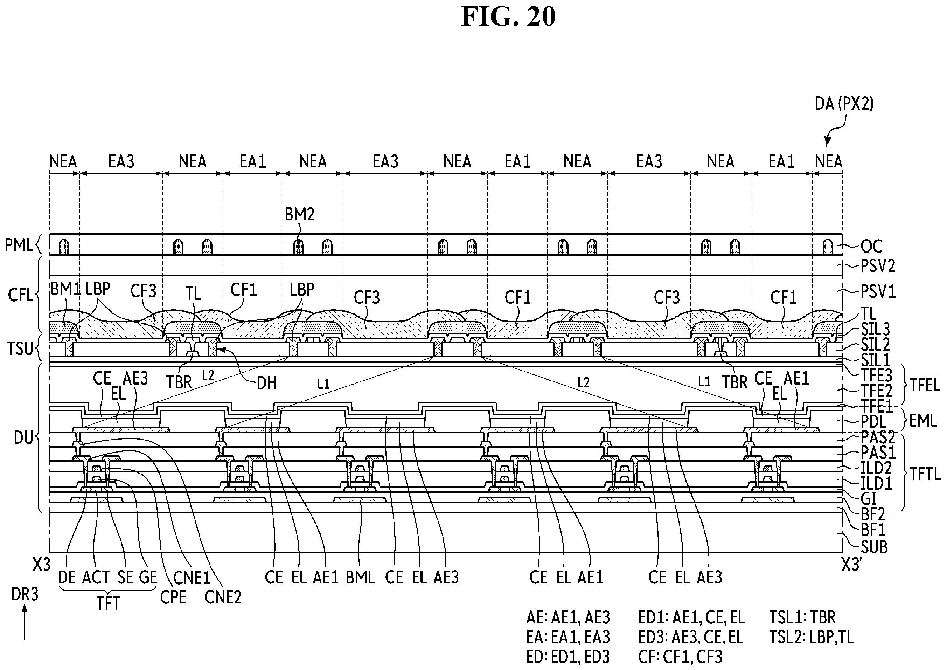

FIG. 20 is a cross-sectional view of a display device. FIG. 20 particularly shows a portion of the display device 10 corresponding to the cross section of the second pixels PX2 taken along line X3-X3' of FIG. 4.

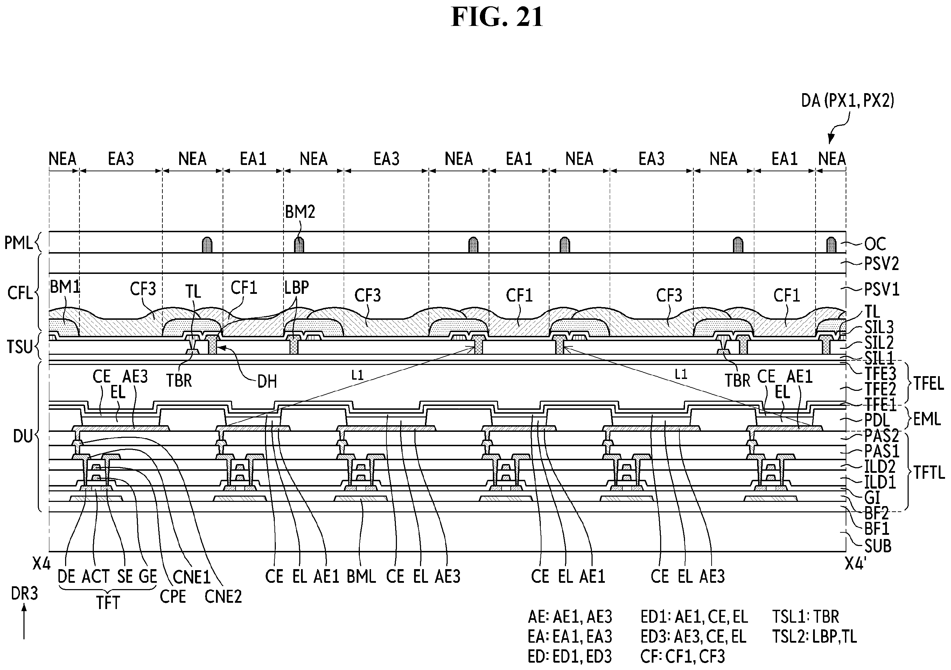

FIG. 21 is a cross-sectional view of a display device. FIG. 21 particularly shows a portion of the display device 10 corresponding to the cross section of the first pixels PX1 and the second pixels PX2 taken along line X4-X4' of FIG. 4.

FIGS. 20 and 21 show the light blocking pattern LBP of the touch sensing layer TSU that differs from FIGS. 16 to 19.

Referring to FIGS. 20 and 21, the light blocking pattern LBP may be disposed in the second conductive layer TSL2 of the touch sensing layer TSU. For example, the second conductive layer TSL2 may include the touch electrode TL and the light blocking pattern LBP.

The second insulating layer SIL2 may include a dummy hole DH overlapping and under the light blocking pattern LBP, and a part of the light blocking pattern LBP may fill the dummy hole DH.

Since the light blocking pattern LBP fills the dummy hole DH in the second insulating layer SIL2, the light blocking pattern LBP may extend closer to the light emitting elements ED of the second pixels PX2. For example, the light blocking pattern LBP may be disposed from a low height closer to the light emitting element layer EML than the touch electrode TL and the first light blocking layer BM1, which are above the height of the second conductive layer TSL2. Accordingly, the light blocking pattern LBP may effectively block the side light emitted from the light emitting elements ED of the second pixels PX2.

The light blocking pattern LBP may be spaced apart from the bridge pattern TBR and the touch electrode TL, and the dummy hole DH may be spaced apart from a contact for connecting the bridge pattern TBR and the touch electrode TL, for example, a contact hole in the second insulating layer SIL2 through which the touch electrode TL passes. The dummy hole DH may have a size greater than that of the contact hole of the second insulating layer SIL2. For example, the dummy hole DH may have a width and/or an area in a plan view greater than that of the contact hole in the second insulating layer SIL2. Accordingly, side light emitted from the light emitting elements ED of the second pixels PX2 may be more effectively blocked.

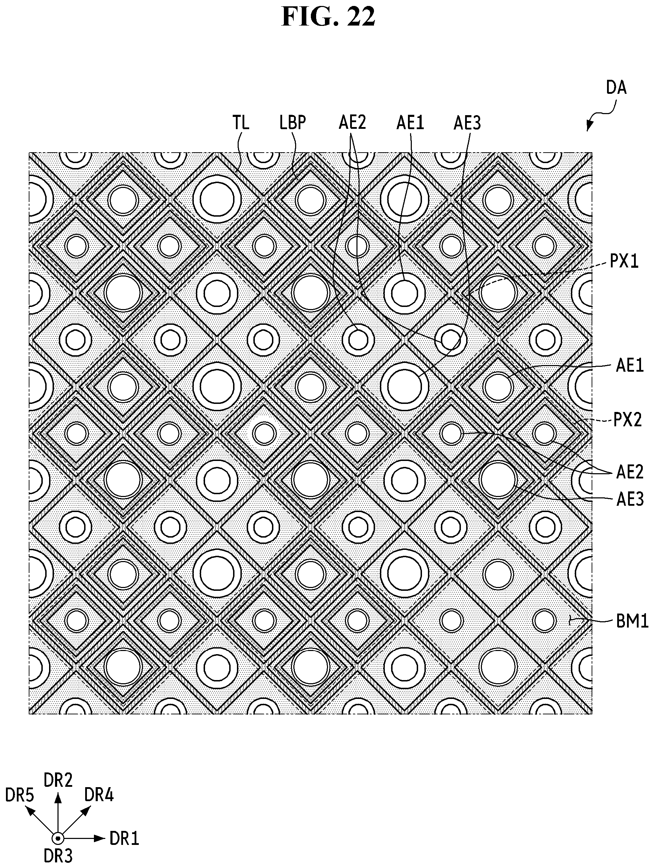

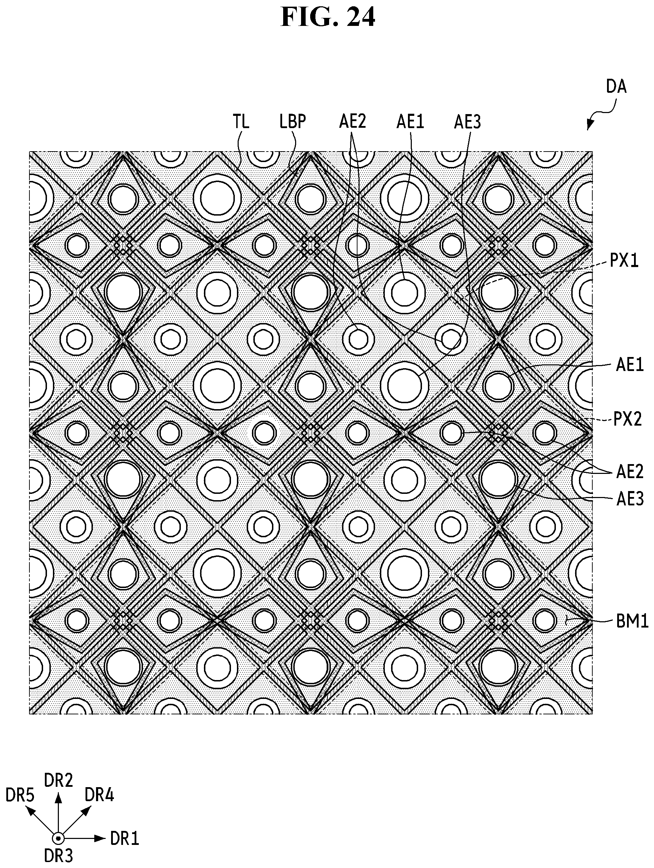

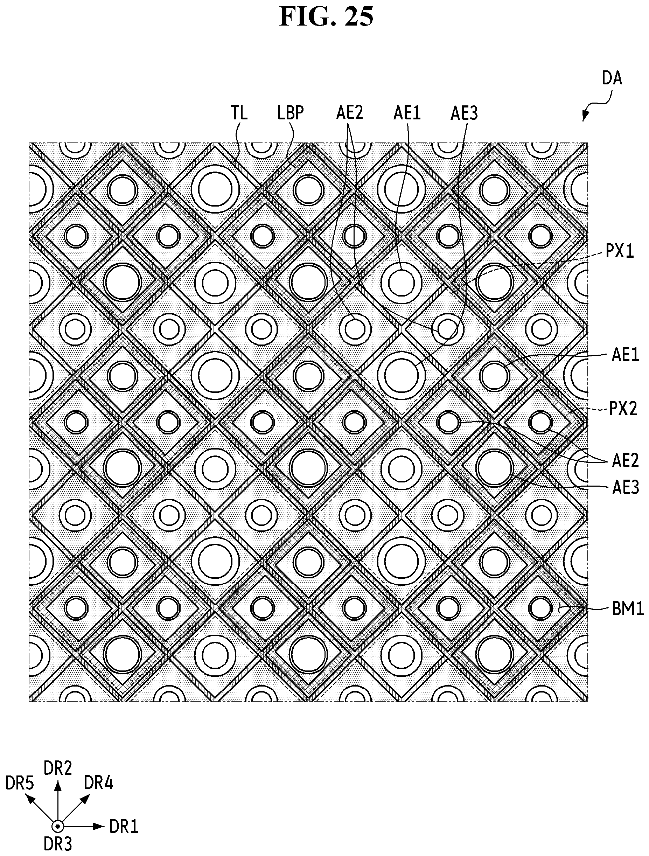

FIGS. 22 to 26 are plan views showing a display area of a display device. Each of FIGS. 22 to 26 particularly shows different examples of the pixel electrodes AE disposed in the display area DA of the display device 10 and the light blocking pattern LBP and the touch electrode TL disposed around the pixel electrodes AE. The examples of FIGS. 22 to 26 primarily differ in relation to the planar shape of the light blocking pattern LBP.

Referring to FIGS. 22 to 26, the light blocking pattern LBP may have various planar shapes. Further, the light blocking pattern LBP may be formed as a plurality of patterns separated from each other while surrounding each emission area EA of the second pixel PX2 or the plurality of emission areas EA disposed in the second pixel PX2, or the light blocking pattern LBP may be formed as patterns connected to each other while surrounding the plurality of emission areas EA of each second pixel PX2 or the emission areas EA of the plurality of second pixels PX2.

FIGS. 22 to 26 show examples in which the touch electrode TL and the light blocking pattern LBP are disposed on different layers, but they are not limited thereto. For example, at least a part of the light blocking pattern LBP may be disposed in the same layer as the touch electrode TL (e.g., as portions of the second conductive layer TSL2). Alternatively, a part of the light blocking pattern LBP may be disposed in the same layer (e.g., the first conductive layer TSL1) as the bridge pattern TBR, and another part of the light blocking pattern LBP may be disposed in the same layer (e.g., the second conductive layer TSL2) as the touch electrode TL.

As shown in FIG. 22, the light blocking pattern LBP may include a plurality of patterns individually surrounding the respective emission areas EA of the second pixel PX2, and the patterns may be separated from each other. The light blocking pattern LBP may be separated from the touch electrode TL and may be disposed closer to the emission areas EA of the second pixel PX2 than the touch electrode TL. The light blocking pattern LBP and the touch electrode TL may be disposed in the same layer or may be disposed in different layers.

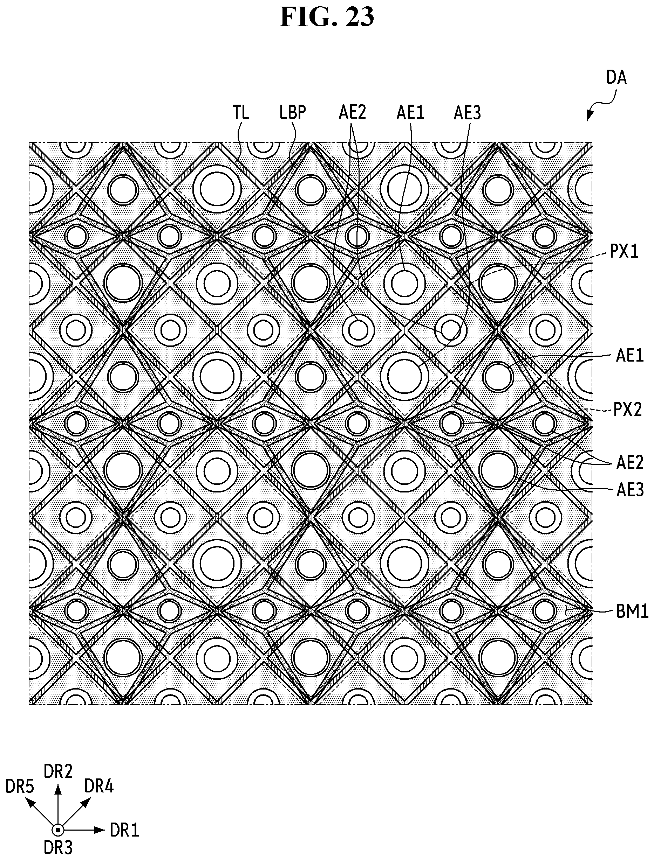

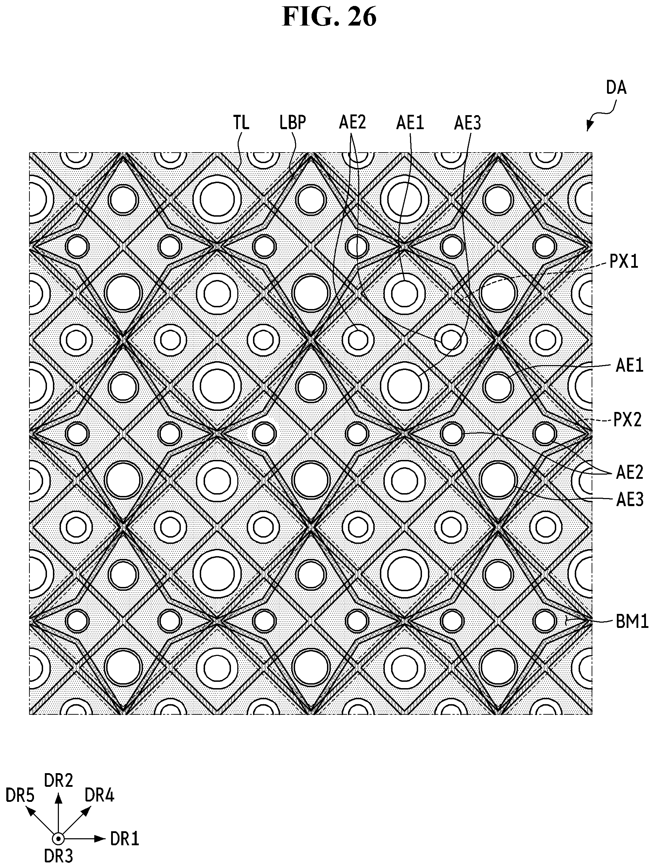

As shown in FIGS. 23 to 26, the light blocking pattern LBP surrounding the respective emission areas EA of the second pixels PX2 may be formed as a single interconnected pattern. The light blocking pattern LBP may individually surround each emission area EA of the second pixels PX2 as shown in FIGS. 23 to 25, or the light blocking pattern LBP may collectively surround the plurality of emission areas EA disposed in each second pixel PX2 as shown in FIG. 26. Although FIGS. 23 to 26 show examples in which the light blocking pattern LBP disposed in the plurality of second pixels PX2 is formed as one pattern, they are not limited thereto. For example, the light blocking patterns LBP disposed in the plurality of second pixels PX2 adjacent to each other may be connected to each other or may be separated from each other.

The size (e.g., width and/or area) of the light blocking pattern LBP may be variously changed. For example, in a plan view (e.g., when viewed from the front direction of the display device 10), the shape, width, area, and/or arrangement shape of the light blocking pattern LBP may be variously changed within a range where the light blocking pattern LBP does not invade the emission areas EA of the pixels PX. For example, the light blocking pattern LBP may be formed as individual patterns surrounding and around the respective emission areas EA of the second pixels PX2 or may be formed as a mesh-shaped pattern including openings exposing the emission areas EA of the second pixels PX2.

The light blocking pattern LBP may have a width less than the width of the touch electrode TL or may have a width greater than or equal to the width of the touch electrode TL. The width of the light blocking pattern LBP may be greater than the width of the touch electrode TL, so that the blocking rate of the side light emitted from the second pixels PX2 may be increased.

The light blocking pattern LBP may or may not overlap the touch electrode TL. For example, the light blocking pattern LBP may overlap or be integrated with at least one touch electrode TL and/or bridge pattern TBR within a range that does not cause short-circuit defects between the touch electrodes TL connected to different wires. For example, light blocking patterns LBP of various shapes, sizes, and/or numbers may be disposed in the display area DA in consideration of spatial conditions (e.g., shape or area of the non-emission area NEA of the second pixels PX2) at the location where the light blocking pattern LBP may be disposed or in consideration of the electrical stability of the touch electrode TL and the bridge pattern TBR.

As described above, the first light blocking layer BM1 and the second light blocking layer BM2 can make the light exit angle or side viewing angle of a subset of the pixels PX (e.g., the second pixels PX2) in the display area DA narrower than the light exit angle or side viewing angle of the other pixels PX (e.g., the first pixels PX1). The side viewing angle of the image displayed in the display area DA may be appropriately varied (e.g., controlled or changed) by selectively driving the pixels PX according to the user's selection. For example, when the display device 10 is driven in the first emission mode according to the user's selection, both the first pixels PX1 and the second pixels PX2 are activated to display an image and, thus, the image may be viewed from the side as well as the front. On the other hand, when the display device 10 is driven in the second emission mode according to the user's selection, the first pixels PX1 are deactivated and only the second pixels PX2 are activated to display an image and, thus, the side viewing angle may be further limited. Accordingly, only a user that is substantially located in the front direction of the display device 10 may view the image in the second emission mode. The display device 10 according to embodiments may increase the user's convenience by varying the side viewing angle of the display device 10 depending on various purposes including privacy protection and the like.

Further, in accordance with the display device 10 of FIGS. 16 to 26, the light leakage of the side light emitted from the second pixels PX2 may be effectively reduced or prevented by disposing, in the touch sensing layer TSU, the light blocking pattern LBP surrounding the emission areas EA of the second pixels PX2 in which the side viewing angle is limited compared to the first pixels PX1. Accordingly, in the second emission mode in which only the second pixels PX2 are selectively driven, it is possible to effectively prevent the image from being visually recognized from the side or prevent the image quality from being deteriorated.

In addition, the light blocking pattern LBP may be disposed in the same layer as at least one of the bridge pattern TBR or the touch electrode TL disposed in the touch sensing layer TSU and used for sensing a touch input. Accordingly, the side light blocking ratio of the second pixels PX2 may be increased without adding a separate process for forming the light blocking pattern LBP.

In concluding the detailed description, those skilled in the art will appreciate that many variations and modifications can be made to the embodiments without substantially departing from the principles of the present invention as defined by the claims. Therefore, the disclosed embodiments are used in a generic and descriptive sense only and not for purposes of limitation.

## Claims

1. A display device comprising:
pixels comprising light emitting elements disposed in respective emission areas, the pixels including first pixels and second pixels;
conductive patterns disposed in a touch sensing layer on the light emitting elements and comprising a touch electrode;
a first light blocking layer disposed on the touch sensing layer and disposed in a non-emission area around the emission areas to surround the emission areas; and
a second light blocking layer disposed on the first light blocking layer and surrounding the emission areas of the second pixels,
the display device further comprising a light blocking pattern disposed in the same layer as at least one of the conductive patterns of the touch sensing layer and surrounding the emission areas of the second pixels.

2. The display device of claim 1, wherein the conductive patterns further comprise a bridge pattern electrically connected to the touch electrode, and
one of the touch electrode and the bridge pattern is disposed in the same layer as the light blocking pattern and contains the same material as the light blocking pattern.

3. The display device of claim 2, wherein the touch sensing layer comprises:
a first conductive layer comprising the bridge pattern;
a second conductive layer comprising the touch electrode; and
an insulating layer disposed between the first conductive layer and the second conductive layer.

4. The display device of claim 3, wherein the first conductive layer further comprises the light blocking pattern, and
the bridge pattern and the light blocking pattern are spaced apart from each other, or
the bridge pattern and the light blocking pattern are integral with each other.

5. The display device of claim 3, wherein the first conductive layer further comprises the light blocking pattern, and
the light blocking pattern is disposed closer to the light emitting elements of the second pixels than the touch electrode and the first light blocking layer are.

6. The display device of claim 3, wherein the second conductive layer further comprises the light blocking pattern.

7. The display device of claim 6, wherein the insulating layer comprises a dummy hole overlapping the light blocking pattern under the light blocking pattern, and
a part of the light blocking pattern extends into the dummy hole.

8. The display device of any one of the preceding claims, wherein the light blocking pattern is disposed closer to the emission areas of the second pixels than the touch electrode is.

9. The display device of any one of the preceding claims, wherein each of the pixels comprises a plurality of emission areas comprising a first emission area emitting light of a first color, a second emission area emitting light of a second color, and a third emission area emitting light of a third color.

10. The display device of claim 9, wherein the light blocking pattern individually surrounds each of the emission areas disposed in each of the second pixels, or wherein the light blocking pattern surrounds the plurality of emission areas disposed in each of the second pixels.

11. The display device of any one of the preceding claims, wherein the touch electrode and the light blocking pattern are disposed in different conductive layers in the touch sensing layer and do not overlap each other, or partially overlap each other.

12. The display device of any one of the preceding claims, wherein the first light blocking layer covers the touch electrode and the light blocking pattern, and/or wherein the second light blocking layer overlaps a part of the first light blocking layer.

13. The display device of any one of the preceding claims, wherein the second light blocking layer is not disposed in the first pixels, and the second light blocking layer is disposed in the second pixels.

14. The display device of claim 13, wherein the first light blocking layer comprises openings exposing the emission areas of the first pixels and openings exposing the emission areas of the second pixels, and
the size of the openings in the first light blocking layer exposing the emission areas of the first pixels and the size of the openings in the first light blocking layer exposing the emission areas of the second pixels are different.

15. An electronic device including a display device, the display device comprising:
pixels comprising light emitting elements disposed in respective emission areas, the pixels including first pixels and second pixels;
conductive patterns disposed in a touch sensing layer on the light emitting elements and comprising a touch electrode;
a first light blocking layer disposed on the touch sensing layer and disposed in a non-emission area around the emission areas to surround the emission areas;
a second light blocking layer disposed on the first light blocking layer and surrounding the emission areas of the second pixels; and
a light blocking pattern disposed in the same layer as at least one of the conductive patterns of the touch sensing layer and surrounding the emission areas of the second pixels.
